# EUROPEAN PATENT SPECIFICATION

(11) **EP 4 575 713 B1**
(45) Date of publication and mention of the grant of the patent: **02.09.2026**
(21) Application number: 24745335.0
(22) Date of filing: 24.07.2024
(51) Int. Cl.: H04M 1/02, G06F 1/16, H05K 1/02, H05K 1/14

(54) **FOLDABLE ELECTRONIC DEVICE AND MULTI-FOLDABLE ELECTRONIC DEVICE INCLUDING SUPPORT PLATE IN WHICH WIRING IS EMBEDDED**
FALTBARE ELEKTRONISCHE VORRICHTUNG UND MEHRFACH FALTBARE ELEKTRONISCHE VORRICHTUNG MIT TRÄGERPLATTE, IN DER DIE VERDRAHTUNG EINGEBETTET IST
DISPOSITIF ÉLECTRONIQUE PLIABLE ET DISPOSITIF ÉLECTRONIQUE MULTI-PLIABLE COMPRENANT UNE PLAQUE DE SUPPORT DANS LAQUELLE UN CÂBLAGE EST INTÉGRÉ

(30) Priority: 28.10.2023 KR 20230146130; 01.12.2023 KR 20230172800
(43) Date of publication of application: 25.06.2025
(73) Proprietor: Samsung Electronics Co., Ltd, Suwon-si, Gyeonggi-do 16677 (KR)
(72) Inventor: KIM, Hyunmuk, Suwon-si Gyeonggi-do 16677 (KR); KIM, Byoungjun, Suwon-si Gyeonggi-do 16677 (KR); KIM, Sunglak, Suwon-si Gyeonggi-do 16677 (KR); RYU, Jooyeol, Suwon-si Gyeonggi-do 16677 (KR); YOON, Shinhyuk, Suwon-si Gyeonggi-do 16677 (KR); JANG, Gyudae, Suwon-si Gyeonggi-do 16677 (KR); JUN, Jaeyoung, Suwon-si Gyeonggi-do 16677 (KR); CHOI, Sunyong, Suwon-si Gyeonggi-do 16677 (KR); CHOI, Jinwook, Suwon-si Gyeonggi-do 16677 (KR)
(74) Representative: Gulde & Partner
(86) International application number: PCT/KR2024/010694
(87) International publication number: WO 2025/089553

(56) References cited:
- WO-A1-2020/184988
- KR-A- 20200 037 953
- KR-A- 20200 101 116
- KR-A- 20220 119 124
- KR-B1- 102 389 913
- US-A1- 2021 105 894

## Description

### [Technical Field]

The present disclosure relates to a foldable electronic device and a multi-foldable electronic device including a support plate with a wiring.

### [Background Art]

A foldable electronic device may have a folded state or an open state. In order to connect electronic components disposed in each housing that composes the foldable electronic device, the foldable electronic device may include a wiring having flexibility.

US 2021/105894 A1 describes a foldable electronic device comprising a flexible display panel with a conductive plate on its rear surface, a circuit board, and a conductive connection member electrically connecting the conductive plate to a ground of the circuit board to prevent display surface protrusion and noise.

WO 2020/184988 A1 describes a foldable electronic apparatus including a flexible display with a conductive plate on its rear surface, the conductive plate having a flexible part with multiple spaced-apart openings to allow bending and improve reliability, assembly, and manufacturing cost.

KR 2020 0101116 A describes a foldable electronic device with an integrated ground structure, featuring a first printed circuit board, PCB, and a second PCB in separate housings interconnected by a wiring member, where a display's first conductive member is grounded to the first PCB, and a second conductive member is grounded to the first PCB via the wiring member, preventing display flickering.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

The present invention is directed to subject matter as defined in the claims.

A foldable electronic device according to an aspect of the present disclosure comprises a first housing. The foldable electronic device comprises a second housing rotatably coupled to the first housing. The foldable electronic device comprises a flexible display including a first display part disposed on the first housing and a second display part disposed on the second housing. The foldable electronic device comprises a hinge structure rotatably connecting the first housing and the second housing. The foldable electronic device comprises a support plate supporting the flexible display. The support plate comprises at least one conductive layer. The at least one conductive layer comprises a conductive pattern disposed on the hinge structure and crosses the hinge structure from the first housing to the second housing to electrically connect a first printed circuit board (PCB) disposed in the first housing and a second PCB disposed in the second housing.

A foldable electronic device according to another aspect of the present disclosure comprises a first housing. The foldable electronic device comprise a second housing rotatably coupled to the first housing. The foldable electronic device comprises a third housing rotatably coupled to the second housing. The foldable electronic device comprises a flexible display including a first display part disposed on the first housing, a second display part disposed on the second housing, a third display part between the first display part and the second display part, the third display part configured to be bent when the first housing and the second housing are folded relative to a first folding axis, a fourth display part disposed on the third housing, and a fifth display part between the second display part and the third display part, the fifth display part configured to be bent when the second housing and the third housing are folded relative to a second folding axis. The foldable electronic device comprises a support plate including a first deformable part arranged in the third display part and having a plurality of slits and a second deformable part arranged in the fifth display part and having a plurality of slits, and having a non-conductive material supporting the flexible display. The support plate includes a first non-conductive (support) layer supporting the flexible display and disposed under the flexible display. The support plate includes at least one conductive layer disposed under the first non-conductive (support) layer, the at least one conductive layer including a first conductive pattern corresponding to at least some of the plurality of slits in the first deformable part and a second conductive pattern corresponding to a portion (at least some) of the plurality of slits in the second deformable part. The support plate includes a second non-conductive (support) layer disposed under the at least one conductive layer. The at least one conductive layer electrically connects a first printed circuit board (PCB) disposed in the first housing, a second PCB disposed in the second housing, and a third PCB disposed in the third housing The support plate may be connected to the first PCB in the first housing, the second PCB in the second housing, and the third PCB in the third housing.

### [Description of the Drawings]

FIG. 1 illustrates an example of an unfolded state of an exemplary multi-foldable electronic device.
FIG. 2 illustrates an example of a folded state of an exemplary multi-foldable electronic device.
FIG. 3 is an exploded view of an exemplary multi-foldable electronic device.
FIG. 4 is a cross-sectional view of a flexible display panel and a support plate of an exemplary foldable electronic device.
FIG. 5 is an exploded view of an exemplary flexible display panel and a support plate.
FIG. 6 is a cross-sectional view of an exemplary support plate including a wiring.
FIG. 7A is a cross-sectional view of an exemplary support plate further including an additional wiring.
FIG. 7B is a cross-sectional view of an exemplary support plate including a conductive via connecting an additional wiring and a wiring.
FIG. 8A is an exemplary diagram illustrating a support layer of a support plate.
FIG. 8B is an exemplary diagram illustrating a conductive layer forming a signal wiring in a support plate.
FIG. 8C is an exemplary diagram illustrating a conductive layer forming a ground in a support plate.
FIG. 9 is a cross-sectional view of an exemplary support plate including conductive layers having a conductive pattern.
FIG. 10A is an exemplary diagram illustrating a first conductive layer having a conductive pattern (structure) extending in a first direction.
FIG. 10B is an exemplary diagram illustrating a second conductive layer having a conductive pattern (structure) extending in a second direction.
FIG. 11 is a cross-sectional view of an exemplary support plate including conductive layers having a conductive pattern (structure) and conductive layers having wirings.
FIG. 12 is a cross-sectional view of an exemplary support plate further including a conductive layer having additional wirings.
FIG. 13 is a diagram illustrating an exemplary disposition of a wiring formed in a conductive layer.
FIG. 14 is a cross-sectional view of an exemplary support plate including a conductive layer including differential wirings.
FIG. 15 is a diagram illustrating an exemplary disposition of a differential wiring disposed in a deformable area.
FIG. 16 is a diagram illustrating a ground line disposed in a deformable area.
FIG. 17A is a cross-sectional view of an exemplary support plate including a plurality of layers including a power wiring.
FIG. 17B is a diagram illustrating a disposition of an exemplary power wiring included in a plurality of layers.
FIG. 18 is a diagram exemplarily illustrating a diffusion path of heat emitted from a heat-generating component in contact with a support plate.
FIG. 19 is a cross-sectional view of an exemplary support plate further including a shielding layer.
FIG. 20 is a cross-sectional view of an exemplary support plate further including a reinforcing layer.
FIG. 21 is a cross-sectional view of an exemplary support plate including a connection portion for connection with a connector.
FIG. 22 is a diagram illustrating connection of an exemplary connector disposed on a support plate for connecting electronic components in an electronic device.
FIG. 23 is a block diagram of an electronic device in a network environment according to various embodiments.

### [Mode for Invention]

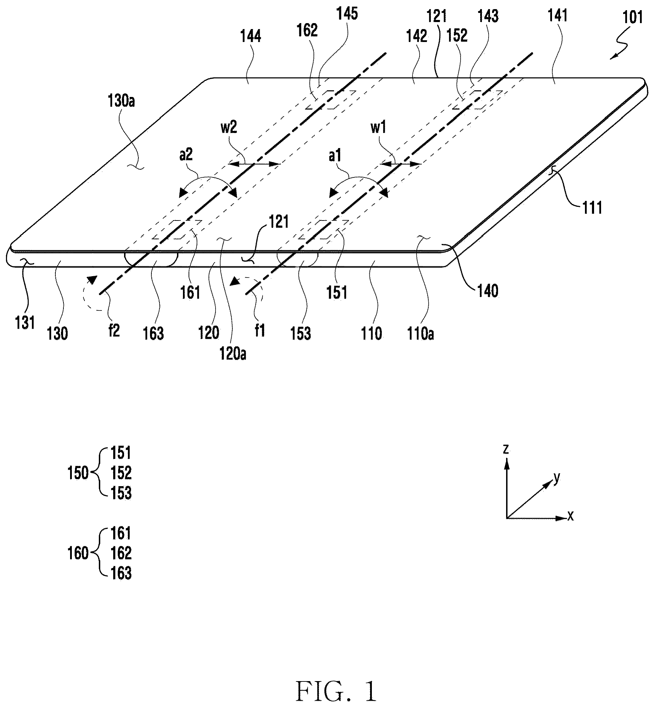

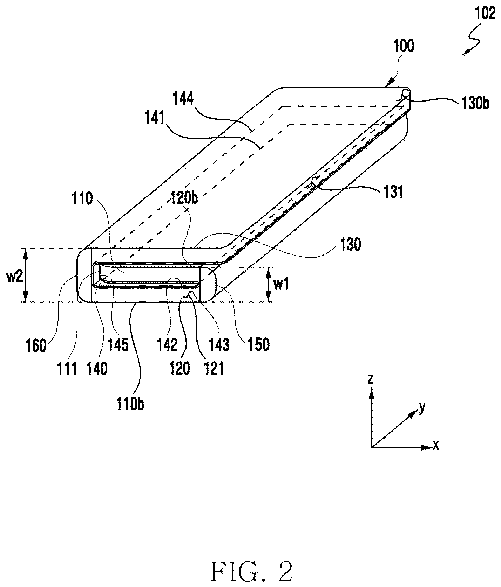

FIG. 1 illustrates an example of an unfolded state of an exemplary multi-foldable electronic device. FIG. 2 illustrates an example of a folded state of the exemplary multi-foldable electronic device.

A display of an electronic device 100 may be folded at least once. In terms of having a folding structure, the display may be referred to as a foldable display or a flexible display. The electronic device 100 may be referred to as a foldable electronic device or a flexible electronic device in terms of including a folding display. The electronic device 100 may be referred to as a multi-foldable electronic device in terms of including a display that folds several times. The electronic device 100, which may be referred to as a multi-foldable electronic device, may have a plurality of folding axes (e.g., a first folding axis f1 and a second folding axis f2).

Referring to FIGS. 1 and 2, the electronic device 100 may include a first housing 110, a second housing 120, a third housing 130, a flexible display 140, a first hinge structure 150, and a second hinge structure 160. The first housing 110 may include a first surface 110a. The second housing 120 may include a second surface 120a. The third housing 130 may include a third surface 130a. The second housing 120 may be pivotably (or rotatably) coupled to the first housing 110. The third housing 130 may be pivotably (or rotatably) coupled to the second housing 120.

According to an embodiment, the flexible display 140 may form at least a portion of an exterior of the electronic device 100. The flexible display 140 may be visually exposed to an outside by being partially disposed in the first housing 110, the second housing 120, and the third housing 130. The flexible display 140 may be disposed on one surface of the first housing 110, the second housing 120, and the third housing 130. For example, the flexible display 140 may be disposed on the first surface 110a, the second surface 120a, and the third surface 130a. In an un-folding state 101 of the electronic device 100, the first surface 110a, the second surface 120a, and the third surface 130a may be referred to as a front surface of the electronic device 100. For example, the first housing 110 may further include a fourth surface 110b opposite to the first surface 110a. The second housing 120 may further include a fifth surface 120b opposite to the second surface 120a. The third housing 130 may further include a sixth surface 130b opposite to the third surface 130a. The fourth surface 110b, the fifth surface 120b, and the sixth surface 130b may be referred to as a rear surface of the electronic device 100 in the un-folding state of the electronic device 100.

According to an embodiment, the flexible display 140 may include a first display part 141, a second display part 142, a fourth display part 144, a third display part 143, and a fifth display part 145. The first display part 141 may be disposed on the first surface 110a of the first housing 110. The second display part 142 may be disposed on the second surface 120a of the second housing 120. The third display part 143 may be located between the first display part 141 and the second display part 142. The fourth display part 144 may be disposed on the third surface 130a of the third housing 130. The fifth display part 145 may be located between the second display part 142 and the fourth display part 144. The first display part 141, the second display part 142, and the fourth display part 144 may be substantially plane regardless of the state of the electronic device 100. The third display part 143 and the fifth display part 145 may change according to the state of the electronic device 100.

The first housing 110 may include a first side surface 111 disposed between the first surface 110a and the fourth surface 110b. The first side surface 111 may extend along a portion of a periphery of the first surface 110a and the fourth surface 110b. The first side surface 111 may surround a space between the first surface 110a and the fourth surface 110b together with the first hinge structure 150. The second housing 120 may include a second side surface 121 disposed between the second surface 120a and the fifth surface 120b. The second side surface 121 may extend along a portion of a periphery of the second surface 120a and the fifth surface 120b. The second side surface 121 may surround a space between the second surface 120a and the fifth surface 120b together with the first hinge structure 150 and the second hinge structure 160. The third housing 130 may include a third side surface 131 disposed between the third surface 130a and the sixth surface 130b. The third side surface 131 may extend along a portion of a periphery of the third surface 130a and the sixth surface 130b. The third side surface 131 may surround a space between the third surface 130a and the sixth surface 130b together with the second hinge structure 160. The first side surface 111, the second side surface 121, and the third side surface 131 may include a conductive material, a non-conductive material, or a combination thereof. For example, the first side surface 111 may include a non-conductive member and conductive members. The conductive members may be spaced apart from each other, and the non-conductive member may be disposed between the conductive members. The first side surface 111 may operate as an antenna radiator by the conductive members and a portion of the non-conductive member.

The first hinge structure 150 may pivotably (or rotatably) connect the first housing 110 and the second housing 120. The first hinge structure 150 may be disposed between the first housing 110 and the second housing 120. The second hinge structure 160 may pivotably (or rotatably) connect the second housing 120 and the third housing 130. The second hinge structure 160 may be disposed between the second housing 120 and the third housing 130. The first hinge structure 150 may be configured to pivot (or rotate) the first housing 110 and the second housing 120 relative to the first folding axis f1.. The first hinge structure 150 may be configured to move the first housing 110 and the second housing 120 in conjunction with each other. The first hinge structure 150 may connect the first housing 110 and the second housing 120 so that the first housing 110 is pivotable (or rotatable) with respect to the second housing 120. The first hinge structure 150 may connect the first housing 110 and the second housing 120 so that the second housing 120 is pivotable (or rotatable) with respect to the first housing 110. The second hinge structure 160 may pivotably (or rotatably) connect the second housing 120 and the third housing 130. The second hinge structure 160 may be disposed between the second housing 120 and the third housing 130. The second hinge structure 160 may be configured to pivot (or rotate) the second housing 120 and the third housing 130 relative to the second folding axis f2. . The second hinge structure 160 may be configured to move the second housing 120 and the third housing 130 in conjunction with each other. The second hinge structure 160 may connect the second housing 120 and the third housing 130 so that the second housing 120 is pivotable (or rotatable) with respect to the third housing 130. The second hinge structure 160 may connect the second housing 120 and the third housing 130 so that the third housing 130 is pivotable (or rotatable) with respect to the second housing 120.

Although the electronic device 100 has been described to include the first hinge structure 150 and the second hinge structure 160, it is not limited thereto. The electronic device 100 may be folded twice or more by including a plurality of hinge structures including the first hinge structure 150 and the second hinge structure 160. The electronic device 100 may provide a user with various user experiences by including a plurality of folding axes provided by the plurality of hinge structures.

Referring to FIG. 1, the first hinge structure 150 and the second hinge structure 160 may be configured to provide the un-folding state 101 in which the first surface 110a, the second surface 120a, and the third surface 130a face a same direction. The un-folding state 101 of the electronic device 100 may be a state in which the first surface 110a, the second surface 120a, and the third surface 130a substantially form a plane. For example, the first surface 110a, the second surface 120a, and the third surface 130a included in the first housing 110, the second housing 120, and the third housing 130, respectively, may each be formed substantially planar. For example, the un-folding state may be a state in which the first display part 141, the second display part 142, and the fourth display part 144 of the flexible display 140 face substantially the same first direction (e.g., +z direction). For example, the un-folding state may be a state in which deformable areas (e.g., the third display part 143 and the fifth display part 145) of the flexible display 140 are unfolded. For example, the un-folding state may be a state in which a first angle a1 between the first housing 110 and the second housing 120 and a second angle a2 between the second housing 120 and the third housing 130 may be substantially 180 degrees, respectively.

Referring to FIG. 2, the first hinge structure 150 and the second hinge structure 160 may be configured to provide folding states in which at least one of the first surface 110a, the second surface 120a, and the third surface 130a faces a different direction. The folding states may mean states in which at least one surface of the first surface 110a and the third surface 130a is inclined with respect to the second surface 120a. For example, the folding states may mean states in which the second surface 120a faces the first direction (e.g., the +z direction) and at least one surface of the first surface 110a and third surface 130a faces a direction different from the first direction. For example, the folding states may be states in which the first surface 110a, the second surface 120a, and the third surface 130a do not form a plane. For example, the folding states may be states in which at least one display part of the first display part 141, the second display part 142, and the fourth display part 144 of the flexible display 140 faces the different direction. For example, the plurality of folding states may be states in which at least some of the deformable areas (e.g., the third display part 143 and the fifth display part 145) may be bent. For example, the folding states may include states in which the first angle a1 between the first housing 110 and the second housing 120 is located within a range of 0 degrees or more and less than 180 degrees. The folding states may include states in which the second angle a2 between the second housing 120 and the third housing 130 is located within the range of 0 degrees or more and less than 180 degrees.

A folding state 102 of the electronic device 100 may be a state in which the second surface 120a faces the first direction (e.g., the +z direction), and the first surface 110a and the third surface 130a face a second direction (e.g., -z direction) opposite to the first direction. For example, the folding state 102 may be a state in which the second surface 120a faces the first surface 110a and the third surface 130a faces the fourth surface 110b. For example, the folding state 102 may be a state in which the first housing 110 is located between the second housing 120 and the third housing 130. The folding state 102 may be a state in which the second display part 142 faces the first direction (e.g., the +z direction), and the first display part 141 and the fourth display part 144 face the second direction (e.g., the -z direction). For example, the folding state 102 may be a state in which the third display part 143 is completely folded and the fifth display part 145 faces the first side surface 111. For example, in the folding state 102, the second housing 120, the first housing 110, and the third housing 130 may be sequentially stacked along the first direction (e.g., the +z direction).

Referring again to FIGS. 1 and 2, the first hinge structure 150 may include a plurality of first hinges 151 and 152. The second hinge structure 160 may include a plurality of second hinges 161 and 162. The first hinges 151 and 152 may be disposed between the first housing 110 and the second housing 120. The first hinges 151 and 152 may pivotably (or rotatably) connect the first housing 110 to the second housing 120. For example, through the first hinges 151 and 152, the first housing 110 may be pivoted (or rotated) relative to the first folding axis f1. Through the first hinges 151 and 152, the second housing 120 may be pivoted (or rotated) relative to the first folding axis f1. According to an embodiment, through rotation of the first housing 110 (or rotation of the second housing 120 or rotation of both the first housing 110 and the second housing 120), the first angle a1 between the second housing 120 and the first housing 110 may be located within a certain angle (e.g., approximately 0 degrees to 180 degrees) range. The certain angle is not limited to 0 degrees to 180 degrees, and the first housing 110 and the second housing 120 may rotate within a support range of the first hinges 151 and 152. The second hinges 161 and 162 may be disposed between the second housing 120 and the third housing 130. The second hinges 161 and 162 may pivotably (or rotatably) connect the third housing 130 to the second housing 120. For example, through the second hinges 161 and 162, the second housing 120 or the third housing 130 may be pivoted (or rotated) relative to the second folding axis f2. According to an embodiment, through rotation of the third housing 130 (or rotation of the second housing 120 or rotation of both of the second housing 120 and the third housing 130), the second angle a2 between the second housing 120 and the third housing 130 may be located within a certain angle (e.g., approximately 0 degrees to 180 degrees) range. The certain angle is not limited to 0 degrees to 180 degrees, and the third housing 130 may rotate within a range supported by the second hinges 161 and 162 with respect to the second housing 120.

According to an embodiment, the first hinge structure 150 may include a first hinge cover 153. The second hinge structure 160 may include a second hinge cover 163. The first hinge cover 153 may be disposed between the first housing 110 and the second housing 120. The first hinges 151 and 152 connecting the first housing 110 and the second housing 120 may be surrounded by the first hinge cover 153. One 151 of the first hinges 151 and 152 may be disposed in a partial area (e.g., one side) in the first hinge cover 153, and another one 152 may be disposed in another partial area (e.g., another side) in the first hinge cover 153. The second hinges 161 and 162 may be surrounded by the second hinge cover 163. The second hinge cover 163 may be disposed between the second housing 120 and the third housing 130. One 161 of the second hinges 161 and 162 connecting the second housing 120 and the third housing 130 may be disposed in a partial area in the second hinge cover 163, and another one 162 may be disposed in another partial area in the second hinge cover 163.

According to an embodiment, the flexible display 140 may include the third display part 143 and the fifth display part 145, which are flexible areas in which at least a portion are bendable flexibly so as to be rotated by the first hinge structure 150 and/or the second hinge structure 160. The third display part 143 may be coupled to the first hinge structure 150. For example, the third display part 143 may be supported by a hinge plate (not illustrated) rotatably coupled to the first hinges 151 and 152. The third display part 143 may be deformed as the first housing 110 (or the second housing 120) rotates relative to the first folding axis f1 with respect to the second housing 120 (or the first housing 110). The fifth display part 145 may be coupled to the second hinge structure 160. For example, the fifth display part 145 may be supported by a hinge plate (not illustrated) rotatably coupled to the second hinges 161 and 162. The fifth display part 145 may be deformed as the third housing 130 (or the second housing 120) rotates relative to the second folding axis f2 with respect to the second housing 120 (or the third housing 130).

According to an embodiment, a first width w1 of the first hinge structure 150 may be smaller than a second width w2 of the second hinge structure 160. For example, the second width w2 may be greater than the first width w1. Through the second width w2 greater than the first width w1, the electronic device 100 in the folding state 102 may provide a space equal to the difference between the second width w2 and the first width w1. In the folding state 102, the space may accommodate the first housing 110. For example, an area of the fifth display part 145 disposed on the second hinge structure 160 may be larger than an area of the third display part 143 disposed on the first hinge structure 150. For example, a width of the fifth display part 145 corresponding to the second width w2 may be greater than a width of the third display part 143 corresponding to the first width w1. For example, when the electronic device 100 changes from the un-folding state to a plurality of folding states, a radius of curvature of the fifth display part 145 may be greater than a radius of curvature of the third display part 143.

Based on the difference between the first width w1 and the second width w2, a housing among the third housing 130 and the first housing 110, which may be folded first, may be determined. For example, the first housing 110 may rotate first with respect to the second housing 120 relative to the first folding axis f1. After the first housing 110 is folded, the third housing 130 may rotate with respect to the second housing 120 relative to the second folding axis f2. As the first width w1 of the first hinge structure 150 is narrower than the second width w2 of the second hinge structure 160, the first housing 110 may be folded to face the second housing 120 first. As the second width w2 of the second hinge structure 160 is wider than the first width w1 of the first hinge structure 150, the third housing 130 may be folded to face the fourth surface 110b of the first housing 110 after the first housing 110 is folded. For example, since the first width w1 of the first hinge structure 150 is smaller than the second width w2 of the second hinge structure 160, the third housing 130 may be stacked on the first housing 110 after the first housing 110 is stacked on the second housing 120 while the electronic device 100 changes from the un-folding state 101 to the folding state 102. The folding state 102 of the electronic device 100 may be a state in which the third housing 130 covers the fourth surface 110b opposite to the first surface 110a of the first housing 110 as the third housing 130 is folded with respect to the second housing 120 after the first housing 110 is folded with respect to the second housing 120. The electronic device 100 may have a G shape when the electronic device 100 is viewed from the side (e.g., when viewed in a +y direction). However, it is not limited thereto.

According to an embodiment, the first side surface 111 of the first housing 110 may be configured to face at least a portion of the flexible display 140 in the folding state 102 of the electronic device 100. While the electronic device 100 changes from the un-folding state 101 to the folding state 102, the first side surface 111 may face at least a portion of the flexible display 140. A portion of the first side surface 111 parallel to the first folding axis f1 may face at least a portion of the fifth display part 145 on the second hinge structure 160.

The electronic device 100 according to the above-described embodiment may provide the flexible display 140 that may be folded at least once by including a plurality of hinge structures 250 and 260. The flexible display 140 may be folded several times through different widths of the hinge structures 250 and 260.

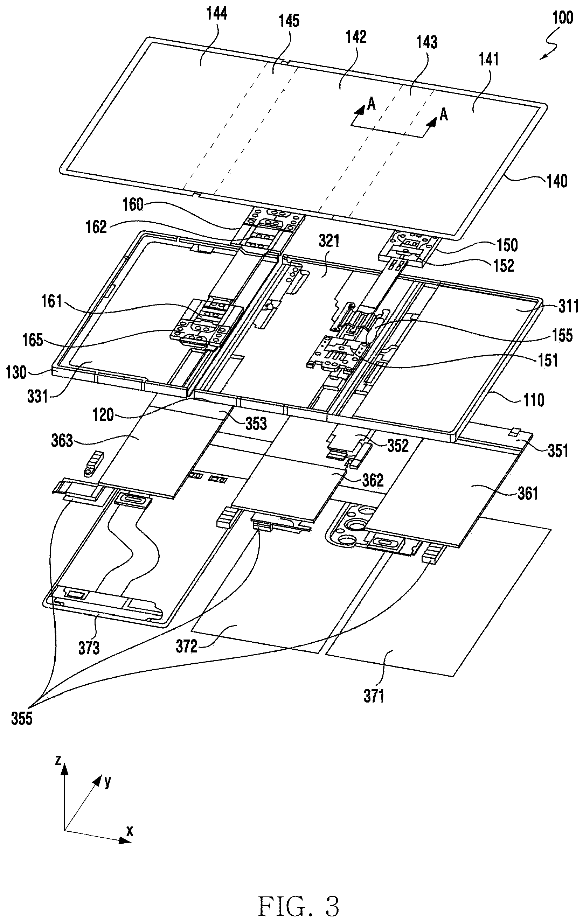

FIG. 3 is an exploded view of an exemplary multi-foldable electronic device.

Referring to FIG. 3, an electronic device 100 may include a first housing 110, a second housing 120, a third housing 130, a display 140, a first hinge structure 150, a second hinge structure 160, a first support member 311, a second support member 321, a third support member 331, a printed circuit board (PCB) 350, a battery 360, rear covers 371 and 372, and a display 373. The electronic device 100 may omit at least one of the components or may additionally include another component. At least one of the components of the electronic device 100 may be the same as or similar to at least one of the components of the electronic device 100 of FIG. 1 or 2, and overlapping descriptions will be omitted below.

The first housing 110, the second housing 120, and the third housing 130 may support the display 140. The electronic device 100 may provide an un-folding state 101 (e.g., the un-folding state 101 of FIG. 1) in which the first housing 110 and the second housing 120 are fully unfolded through the first hinge structure 150, and the second housing 120 and the third housing 130 are fully unfolded through the second hinge structure 160. First hinge plates 155 may be attached to first hinges 151 and 152. The first support member 311 of the first housing 110 and the second support member 321 of the second housing 120 attached to the first hinge plates 155 may rotate through a movement of the first hinge structure 150. Second hinge plates 165 may be attached to second hinges 161 and 162. The second support member 321 of the second housing 120 and the third support member 331 of the third housing 130 attached to the second hinge plates 165 may rotate through a movement of the second hinge structure 160. The first hinges 151 and 152 may include hinge gears that configured to rotate each of the first hinge plates 155 relative to a first folding axis f1. The second hinges 161 and 162 may include hinge gears that rotate each of the second hinge plates 165 relative to a second folding axis f2. The hinge gears may rotate each of the hinge plates 155 and 165 while the hinge gears being engaged with each other and rotating. The first hinge structure 150 or the second hinge structure 160 may include components (e.g., a rotate, an arm, a pulley, or a pin) other than the structure. A display panel may include a front surface that provides information by emitting light and a rear surface opposite to the front surface. In the un-folding state 101, a first display part 141, a second display part 142, and a fourth display part 144 of the display 140 may face a same direction. In the un-folding state 101, a third display part 143 and a fifth display part 145 of the display 140 may be in a substantially unfolded state. In a folding state (e.g., the folding state 102 of FIG. 2), the first display part 141 and the second display part 142 of the display 140 face each other, and the fourth display part 144 may face a direction opposite to the direction in which the second display part 142 faces and may face the same direction as the direction in which the first display part 141 faces. In the folding state 102, the third display part 143 and the fifth display part 145 of the display 140 may be in a folded state. The electronic device 100 may include an intermediate state between the un-folding state 101 and the folding state 102. The intermediate state may be a state in which the first housing 110 and the second housing 120 among the first housing 110, the second housing 120, and the third housing 130 are folded, and the second housing 120 and the third housing 130 are unfolded. In addition to the above state, the intermediate state may include a state of the electronic device 100 while changing from the un-folding state 101 to the folding state 102. For example, the intermediate state may include a state in which a direction that a front surface of each of the first housing 110, the second housing 120, and the third housing 130 views is different. In the intermediate state, a first surface 110a, a second surface 120a, and a third surface 130a may face different directions from each other.

The first housing 110 may include the first support member 311. The first support member 311 may be partially surrounded by a first side surface 111. The first support member 311 may be integrally formed with the first side surface 111. For example, the first support member 311 may be a plate extending from the first side surface 111 to the inside of the first housing 110. The first support member 311 and the first side surface 111 may be formed by processing from one base material, or may include a conductive material and a non-conductive material, or a combination thereof through a double injection process. The second housing 120 may include the second support member 321. The second support member 321 may be integrally formed with a second side surface 121. For example, the second support member 321 may be a plate extending from the second side surface 121 to the inside of the second housing 120. The second support member 321 and the second side surface 121 may be formed by processing from one base material, or may include a conductive material and a non-conductive material, or a combination thereof through a double injection process. The third housing 130 may include the third support member 331. The third support member 331 may be integrally formed with a third side surface 131. For example, the third support member 331 may be a plate extending from the third side surface 131 to the inside of the third housing 130. The third support member 331 and the third side surface 131 may be formed by processing from one base material, or may include a conductive material and a non-conductive material, or a combination thereof through a double injection process. The first side surface 111, the second side surface 121, and the third side surface 131 may be referred to as a frame or chassis in terms of providing the appearance of the electronic device 100.

In a state in which the electronic device 100 is assembled, one surface (e.g., a front surface) of the first support member 311, one surface of the second support member 321, and one surface of the third support member 331 may support the display 140. In a state in which the electronic device 100 is assembled, another surface (e.g., a rear surface) of the first support member 311, another surface of the second support member 321, and another surface of the third support member 331 may support the PCB 350 or the battery 360. For example, a first PCB 351 and a first battery 361 in the first housing 110 may be disposed between the first support member 311 and the first rear cover 371. A second PCB 352 and a second battery 362 in the second housing 120 may be disposed between the second support member 321 and the second rear cover 372. A third PCB 353 and a third battery 363 in the third housing 130 may be disposed between the third support member 331 and the display 373. The first support member 311, the second support member 321, and the third support member 331 may be referred to as a support structure or bracket in terms of supporting an electronic component and providing a disposition space for the electronic component.

The electronic device 100 may further include PCBs 355. Electronic components for implementing various functions of the electronic device 100 may be disposed on the PCB 350. For example, components for implementing the overall function of the electronic device 100 may be disposed on the second PCB 352. Electronic components for implementing some functions of the second PCB 352 may be disposed on the first PCB 351, the third PCB 353, and the PCBs 355. Components for driving the display 373 disposed on the third housing 130 may be disposed on the third PCB 353. The first PCB 351, the second PCB 352, the third PCB 353, and the PCBs 355 may be electrically connected to each other. The first PCB 351, the second PCB 352, and the third PCB 353 may be electrically connected through a line disposed inside the electronic device 100. A line connecting the first PCB 351 and the second PCB 352 may cross the first hinge structure 150 located between the first housing 110 and the second housing 120. A portion of the line connecting the first PCB 351 and the second PCB 352 may be disposed in a deformable area of a support plate supporting the display panel corresponding to the third display part 143 of the display 140. A line connecting the second PCB 352 and the third PCB 353 may cross the second hinge structure 160 located between the second housing 120 and the third housing 130. A portion of the line connecting the second PCB 352 and the third PCB 353 may be disposed in the deformable area of the support plate supporting the display panel corresponding to the fifth display part 145 of the display 140.

The battery 360 is a device for supplying power to at least one component of the electronic device 100 and may include, for example, a non-rechargeable primary battery, a rechargeable secondary battery, or fuel cell. At least a portion of the battery 360 may be disposed substantially coplanar with the PCB 350. For example, the surface formed as substantially coplanar of the battery and the PCB 350 may be disposed on the another surface of the first support member 311 (e.g., the rear surface, or a surface facing the first rear cover 371, the second rear cover 372 or the display 373), the another surface of the second support member 321, and the another surface of the third support member 331.

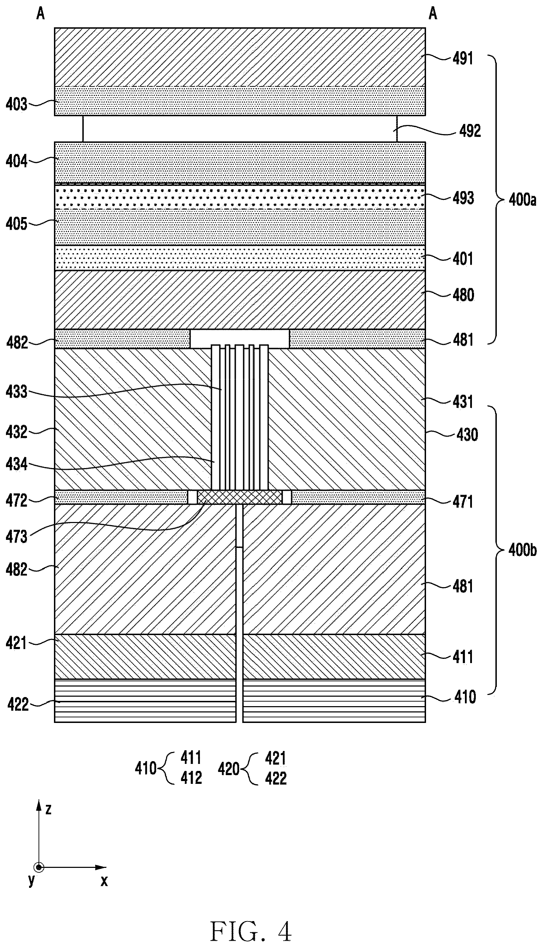

Although the electronic device 100 has been described to include a plurality of hinge structures, it is not limited thereto. For example, the electronic device 100 may be a foldable electronic device including the first hinge structure 150 connecting the first housing 110 and the second housing 120. The configuration of a support member (or support plate) to be described later in FIG. 4 may be applied to both a multi-foldable electronic device including the plurality of hinge structures and a foldable electronic device including one hinge structure.

FIG. 4 is a cross-sectional view of a flexible display panel, a support plate, and an input device of an exemplary foldable electronic device.

FIG. 4 is a cross-sectional view (e.g., a cross-sectional view in which the display 140 of FIG. 3 is cut along A-A) in which an exemplary display 140 is cut.

Referring to FIG. 4, the display 140 may include a display panel 401, a first layer 491, a window 492, a second layer 493, and a protection layer 480.

The window 492 may be disposed on one surface (e.g., the front surface) of the display panel 401 facing an outside of an electronic device 100. The window 492 may protect the display panel 401. The window 492 may include a transparent material to transmit light emitted from display panel 401 to the outside. The display panel 401 may provide visual information based on the transmission of the light through the window 492. The display 140 may further include adhesive layers 403, 404, and 405 disposed between the first layer 491, the window 492, the second layer 493, and the display panel 401. The first layer 491, the window 492, and the second layer 493 may include at least a portion of a transparent portion to transmit the light emitted from the display panel 401 to the outside. The first layer 491, the window 492, and/or the second layer 493 may include a polymer material or a glass material. For example, the window 492 may reinforce a rigidity of the display 140 by being formed of the glass material. The windows 492 may include the glass material formed to have ductility for deformation of the display 140 while a state of the electronic device 100 changes (e.g., while changing from the un-folding state to the folding state or from the folding state to the un-folding state). For example, the window 492 may include an ultra-thin glass (UTG) formed as a thin film. According to an embodiment, the window 492 may include a polymer material such as polyimide (PI).

The first layer 491 and/or the second layer 493 may include a thin film made of a polymer material having ductility. The polymer material may include either PI or PET (polyethylene terephthalate). The first layer 491 may be referred to as a protection layer or a protection film in terms of being a layer for protecting the window 492. The first layer 491 may include a polymer material such as PET. In order to remove a scratch on a surface of the display 140, the first layer 491 may require replacement or removal. For the replacement of the first layer 491, viscosity of the first adhesive layer 403 may be lower than that of the other adhesive layers 404 and 405. The adhesive layers 403, 404, and 405 may be transparent adhesive layers capable of transmitting light. For example, the adhesive layers 403, 404, and 405 may include a pressure sensitive adhesive (PSA) or an optical clear adhesive (OCA).

The second layer 493 may include a protection layer or a polarizing layer made of a polymer material such as PET. The second layer 493 may be a layer for protecting the display panel 401. The second layer 493 may improve the clarity of visual information (image or video) provided from the display panel 401.

A display 230 may further include a coating layer disposed on the first layer 491. A rigidity of the coating layer may be higher than that of the first layer 491 and the second layer 493. The coating layer stacked on an outermost side may have a scratch resistance characteristic. The coating layer has been described as a layer disposed on the first layer 491, but may be disposed in various locations as needed. The coating layer may include one of an anti-reflection (AR) coating, a low reflection (LR) coating, a shatter proof (SP) coating, an anti-fingerprint (AF) coating, or a combination thereof.

The display 140 may further include the protection layer 480 disposed on another surface (e.g., the rear surface) of the display panel 401. The window 492 may be disposed on one surface (e.g., the front surface) of the display panel 401. The protection layer 480 may be disposed on another surface (e.g., the rear surface) of the display panel 401. The protection layer 480 may be a film for protecting the display panel 401. The protection layer 480 may include a polymer material such as PET. The protection layer 480 may absorb impact transmitted from a lower portion (e.g., a portion that another surface of the display panel 401 faces) of the display panel 401. For example, the protection layer 480 may reduce damage (e.g., dent, scratch) caused by a support plate 430, which has rigidity and disposed under the display panel 401. In terms of reducing the impact transmitted to the display panel 401, the protection layer 480 may be referred to as an impact absorbing layer or a buffer layer.

The display panel 401, the protection layer 480, the first layer 491, the window 492, the second layer 493, and the adhesive layers 403, 404, and 405 may be referred to a superstructure 400a of the display or a display panel structure in terms of being on the top or front of the display panel 401.

The support plate 430 may guide a shape of a deformable flexible display and support the display 140. In order to support the display 140, the support plate 430 may include a portion having the rigidity, and for deformation of the display 140, the support plate 430 may include a portion having the ductility. The support plate 430 may include a plurality of planar parts 431 and 432 and a deformable part 433. For example, the first planar part 431 among the plurality of planar parts 431 and 432 may support a first display part 141, and the second planar part 432 among the plurality of planar parts 431 and 432 may support a second display part 142. The deformable part 433 may support a third display part 143. The deformable part 433 may include slits 434 parallel to a first folding axis f for deformation of the third display part 143. The support plate 430 may be attached to the protection layer 480 through adhesive members 481 and 482.

The above-described support plate 430 has been described as including the first planar part 431, the second planar part 432, and the deformable part 433, but the support plate 430 may further include another deformable part (not illustrated) different from the deformable part 433. For example, the support plate 430 may further include a third planar part (not illustrated) that supports a fourth display part 144. The support plate 430 may further include another deformable part that supports a fifth display part 145 disposed between the fourth display part 144 and the second display part 142. The another deformable part may include slits parallel to a second folding axis f2 for deformation of the fifth display part 145. In case that the display 140 further includes a deformable area in addition to the third display part 143 and the fifth display part 145, the support plate 430 may include more deformable parts.

The planar parts 431 and 432 may be referred to as a non-deformable portion or a rigid portion, in terms of having the rigidity to support the non-deformable portion or a portion that is maintained as planar of the display 140. The deformable part 433 may be referred to as a deformable portion or a ductility portion, in terms of supporting the deformable portion (e.g., the third display part 143 or the fifth display part 145) of the display 140 and having ductility to support the deformable portion.

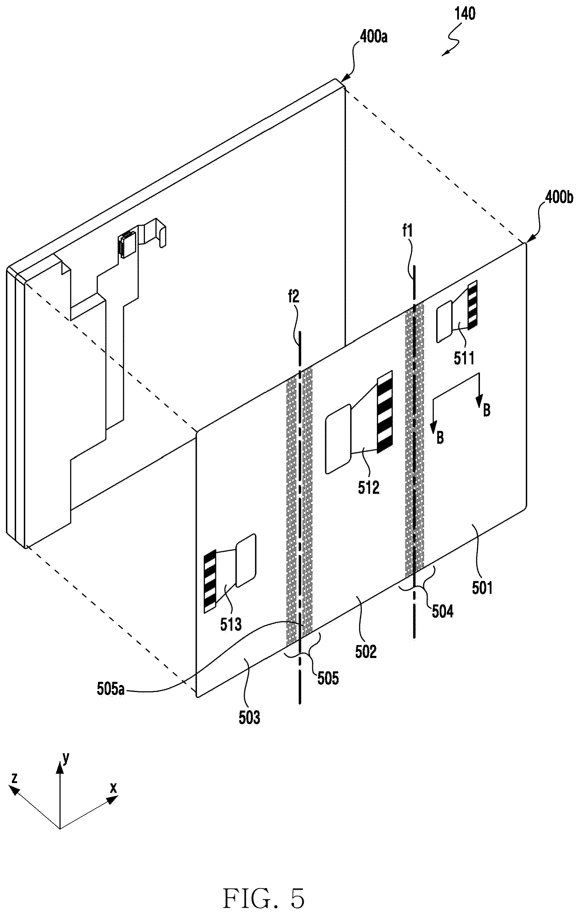

The support plate 430 may be configured to maintain the plane of the display 140 in the planar parts 431 and 432, and to enable deformation of the display 140 in the deformable part 433. The support plate 430 may include a glass fiber reinforced plastic (GFRP), a carbon fiber reinforced plastic (CFRP), and a combination thereof. The support plate 430 may be formed of a plurality of layers. The support plate 430 may include a conductive layer, a non-conductive layer, or a combination thereof. The conductive layer included in the support plate 430 may electrically connect a PCB (e.g., the PCB 350 of FIG. 3) disposed in each housing. The configuration of the conductive layer will be described later in FIG. 5 and below.

The support plate 430 may be in contact with a first electromagnetic induction panel 481 and a second electromagnetic induction panel 482. The first electromagnetic induction panel 481 may be attached to the first planar part 431 of the support plate 430, and the second electromagnetic induction panel 482 may be attached to the second planar part 432 of the support plate 430. In an area corresponding to the third display part 143, the first electromagnetic induction panel 481 may be disposed under a portion of the deformable part 433, and the second electromagnetic induction panel 482 may be disposed under the remaining portion of the deformable part 433. The first electromagnetic induction panel 481 and the second electromagnetic induction panel 482 may be spaced apart from each other. The first electromagnetic induction panel 481 and the second electromagnetic induction panel 482 may be a layer including a conductive pattern (structure). The conductive pattern (structure) may be configured to electromagnetically interact with an external object. For example, the conductive pattern (structure) may be a digitizer configured to identify an input through a stylus pen. The conductive pattern (structure) or the first electromagnetic induction panel 481 and the second electromagnetic induction panel 482 may be replaced with the conductive layer included in the support plate 430.

The electronic device 100 may further include adhesive layers 471 and 472. The adhesive layer 471 may attach the first electromagnetic induction panel 481 and the first planar part 431 of the support plate 430, and the adhesive layer 472 may attach the second electromagnetic induction panel 482 and the second planar part 432 of the support plate 430. The first electromagnetic induction panel 481 and the second electromagnetic induction panel 482 may be spaced apart from each other. The electronic device 100 may further include an elastic layer 473. The elastic layer 473 may be disposed between the first electromagnetic induction panel 481 and the second electromagnetic induction panel 482. The elastic layer 473 may reduce impact transmitted to an electronic component disposed under the display 140, caused by the support plate 430. The elastic layer 473 may include thermoplastic polyurethane (TPU), PET, PI, or a combination thereof.

The electronic device 100 may further include functional layers 410 and 420 disposed in the lower portion of the support plate 430. The functional layers 410 and 420 may include a magnetic material or a metal layer for shielding. For example, in case of including the first electromagnetic induction panel 481, the second electromagnetic induction panel 482, and the support plate 430 that includes a conductive layer therein, in which a line or an wiring is included, the functional layers 410 and 420 may include magnetic layers 411 and 412 including the magnetic material for inducing magnetic force generated from the electromagnetic induction panel along the functional layers 410 and 420 in contact with the electromagnetic induction panel. According to an embodiment, the magnetic layers 411 and 412 may be disposed to increase the density of a magnetic flux generated from the electromagnetic induction panel.

The functional layers 410 and 420 may include shielding layers 421 and 422 to prevent signals flowing along the conductive layer in the support plate 430 or the conductive pattern (structure) in the first electromagnetic induction panel 481 and the second electromagnetic induction panel 482 from being interfered by an external electrical signal. Some of the functional layers 410 and 420 may be included in the support plate 430.

The functional layers 410 and 420, the first electromagnetic induction panel 481, the second electromagnetic induction panel 482, the support plate 430, the adhesive layers 471 and 472, and the elastic layer 473 may be referred to as a display substructure 400b, in terms of being located at the lower portion of the display panel 401.

FIG. 5 is an exploded view of an exemplary flexible display panel and a support plate.

Referring to FIG. 5, a display 140 may include a display superstructure 400a and a display substructure 400b.

The display superstructure 400a may include a display panel (e.g., the display panel 401 of FIG. 4) and protection layers. The display substructure 400b may include structures for guiding or supporting deformation of the display panel 401, and be disposed under the display panel 401.

A support plate 430 may include a first planar part 501 (e.g., the first planar part 431 of FIG. 4), a second planar part 502 (e.g., the second planar part 432 of FIG. 4), a third planar part 503, a first deformable part 504, and/or a second deformable part 505.

The support plate 430 may support the superstructure 400a of the display. The first planar part 501, the second planar part 502, and the third planar part 503 may support a non-deformable area (e.g., the first display part 141, the second display part 142, or the fourth display part 144) of the display 140. The first deformable part 504 and the second deformable part 505 may support a deformable area (e.g., an area including the third display part 143 or the fifth display part 145) of the display 140.

The first deformable part 504 may be deformed to rotate the first planar part 501 and the second planar part 502 relative to a first folding axis f1. The second deformable part 505 may be deformed to rotate the second planar part 502 and the third planar part 503 relative to a second folding axis f2. The first deformable part 504 and the second deformable part 505 may include slits 434 parallel to the first folding axis f1 or the second folding axis f2. The first deformable part 504 and the second deformable part 505 may be disposed to repeat the same slits 434. Without being limited thereto, the slits may include different slits in some areas. Although the slits 434 have been described as being parallel to the first folding axis f1 or the second folding axis f2, at least some of the slits 434 may have an inclination with respect to the first folding axis f1 or the second folding axis f2.

The slits 434 have been described as being disposed in the first deformable part 504 and the second deformable part 505, which are the remaining portion of the first planar part 501, the second planar part 502, and the third planar part 503, but slits 434 may be disposed in a portion of the first planar part 501, a portion of the second planar part 502, or a portion of the third planar part 503. For example, the slits 434 may be disposed in a portion in contact with the first deformable part 504 of the first planar part 501, may be disposed in a portion in contact with the first deformable part 504 and the second deformable part 505 of the second planar part 502, and may be disposed in a portion in contact with the second deformable part 505 of the third planar part 503.

Widths of the first deformable part 504 and the second deformable part 505 may be determined by a first width w1 of the third display part 143 and a second width w2 of the fifth display part 145, respectively. The second deformable part 505 having a width wider than that of the first deformable part 504 may include a planar portion 505a. The planar portion 505a may be a portion that maintains a plane in a folding state (e.g., the folding state 102 of FIG. 2) as a hinge width increases. The planar portion 505a may be a portion toward which a portion of a first side surface 111 of a first housing (e.g., the first housing 110 of FIG. 1) faces in the folding state 102. In the folding state 102, the planar portion 505a may be configured to provide an accommodation space for the first housing 110.

Although the support plate 430 has been described as including two deformable parts 504 and 505, the number of deformable parts may be determined according to the number of deformable portions of the display 140. For example, a foldable electronic device having one deformable portion of the display 140 may include a support plate having one deformable part. A foldable electronic device having three deformable portions of the display 140 may include a support plate having three deformable parts.

The support plate 430 may further include a first connector 511, a second connector 512, and/or a third connector 513. The first connector 511 may be disposed on the first planar part 501, the second connector 512 may be disposed on the second planar part 502, and the third connector 513 may be disposed on the third planar part 503. Each of the planar parts 501, 502, and 503 has been described as including one connector, but may further include a plurality of connectors as needed. The minimum number of connectors may be determined according to the number of planar parts. For example, a foldable electronic device having two planar parts may include at least two connectors disposed on each of the planar parts.

The first connector 511, the second connector 512, and the third connector 513 may be connected to a wiring disposed in the support plate 430. The first connector 511 connected to the wiring in the support plate 430 may be electrically connected to a first PCB 351 (e.g., the first PCB 351 of FIG. 3) or a first battery 361 (e.g., the first battery 361 of FIG. 3) disposed in the first housing 110 (e.g., the first housing 110 of FIG. 1). The second connector 512 connected to the wiring in the support plate 430 may be electrically connected to a second PCB 352 (e.g., the second PCB 352 of FIG. 3) or a second battery 362 (e.g., the second battery 362 of FIG. 3) disposed in a second housing 120 (e.g., the second housing 120 of FIG. 1). The third connector 513 connected to the wiring in the support plate 430 may be electrically connected to a third PCB 353 (e.g., the third PCB 353 of FIG. 3) or a third battery 363 (e.g., the third battery 363 of FIG. 3) disposed in a third housing 130 (e.g., the third housing 130 of FIG. 1). The first PCB 351, the second PCB 352, the third PCB 353, the first battery 361, the second battery 362, and the third battery 363 through the first connector 511, the second connector 512, and the third connector 513 may be electrically connected to each other.

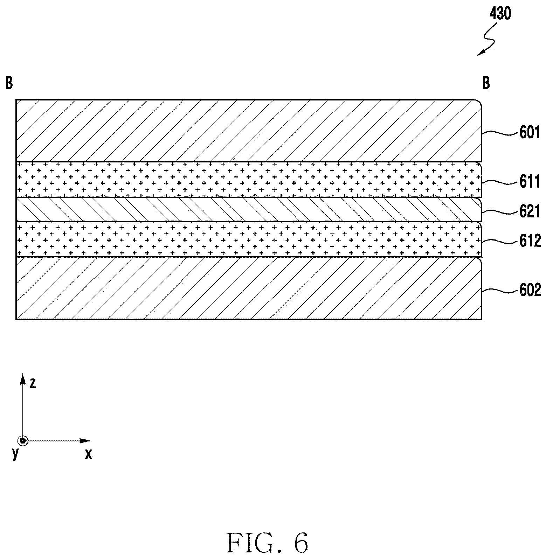

A wiring relationship in the support plate 430 will be described in FIG. 6 and below.

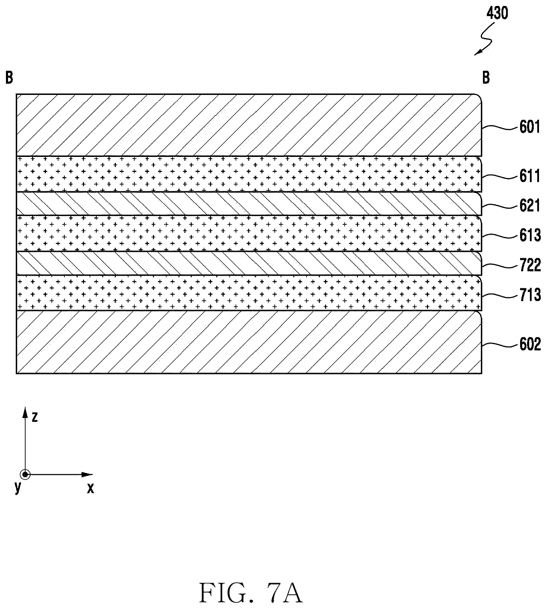

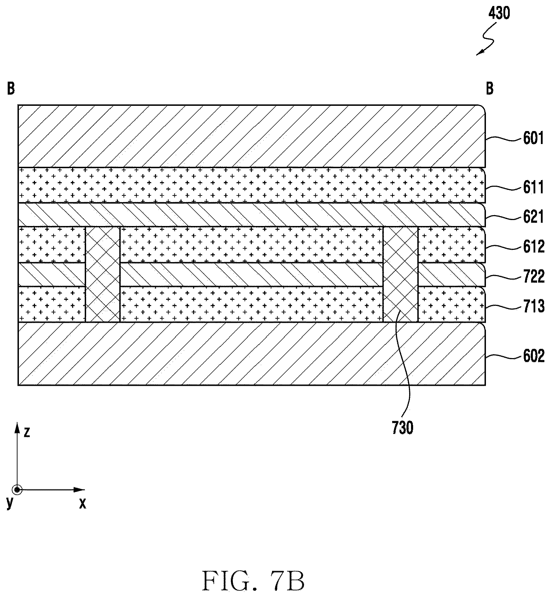

FIG. 6 is a cross-sectional view of an exemplary support plate including a wiring. FIG. 7A is a cross-sectional view of an exemplary support plate further including an additional wiring. FIG. 7B is a cross-sectional view of an exemplary support plate including a conductive via connecting an additional wiring and a wiring.

FIGS. 6, 7A, and 7B are cross-sectional views (e.g., cross-sectional views cut along B-B of FIG. 5) in which a support plate 430 of a display 140 is cut.

Referring to FIGS. 6, 7A, and 7B, the support plate 430 may include a first support layer 601, a second support layer 602, a first conductive layer 611, a second conductive layer 612, and/or a non-conductive layer 621.

The first support layer 601 and the second support layer 602 may include a substantially non-conductive material. For example, a relative permittivity of the first support layer 601 and the second support layer 602 may be lower than a relative permittivity of the first conductive layer 611 and the second conductive layer 612. The relative permittivity of the first support layer 601 and the second support layer 602 may be approximately 1 to 5. The first support layer 601 and the second support layer 602 may include a glass fiber reinforced plastic (GFRP). The first support layer 601 may form a surface of the support plate 430 facing a superstructure 400a (e.g., the display superstructure 400a of FIG. 4) of the display. The first support layer 601 may be in contact with the display superstructure 400a. The first support layer 601 may be attached to a protective layer 480 (e.g., the protective layer 480 of FIG. 4) attached to a display panel 401 (e.g., the display panel 401 of FIG. 4). The first support layer 601 and the second support layer 602 may include a planar part corresponding to planar parts (e.g., the first planar part 431 of FIG.4, the second planar part 432 of FIG. 4, the first planar part 501 of FIG. 5, the second planar part 502 of FIG. 5, or the third planar part 503 of FIG. 5), and may include deformable parts (e.g., the deformable part 433 of FIG. 4, the first deformable part 504 of FIG.5, or the second deformable part 505 of FIG. 5) having a plurality of slits (e.g., the slits 434 of FIG. 4).

The first conductive layer 611 may include a conductive film. The first conductive layer 611 may be electrically connected to a conductive portion (e.g., the metal portion in the electronic device 100, the housings 110, 120, and 130, or support members 311, 321, and 331) disposed in the electronic device 100. The first conductive layer 611 may operate as a ground layer or a ground. The first conductive layer 611 may include a metal film (e.g., copper foil).

The second conductive layer 612 may include a conductive line (or a wiring). The second conductive layer 612 may include a copper foil pattern (structure) or a copper line. The second conductive layer 612 may be electrically connected to a first PCB (e.g., the first PCB 351 of FIG. 3), a second PCB (e.g., the second PCB 352 of FIG. 3), a third PCB (e.g., the third PCB 353 of FIG. 3), a first battery (e.g., the first battery 361 of FIG. 3), a second battery (e.g., the second battery 362 of FIG. 3), or a third battery (e.g., the third battery 363 of FIG. 3) disposed in each of the housings (e.g., the first housing 110, the second housing 120, or the third housing 130 of FIG. 1). The second conductive layer 612 may electrically connect electronic components disposed in the first PCB 351, the second PCB 352, or the third PCB 353 through connectors (e.g., the first connector 511, the second connector 512, and the third connector 513 of FIG. 5). For example, the second conductive layer 612 may electrically connect at least one processor disposed on the second PCB 352 and an antenna module disposed on the first PCB 351. The second conductive layer 612 may transmit a wireless communication signal for transmission to an external electronic device from the at least one processor disposed on the second PCB 352 to the antenna module disposed on the first PCB 351. The second conductive layer 612 may transmit a wireless communication signal received from the external electronic device from the antenna module disposed on the first PCB 351 to the at least one processor disposed on the second PCB 352. For example, the second conductive layer 612 may electrically connect the at least one processor disposed on the second PCB 352 and a display driver integrated circuit (DDI) connected to the third PCB 353. The second conductive layer 612 may transmit a signal related to display control from the at least one processor to the display driver integrated circuit.

The non-conductive layer 621 may be disposed between the first conductive layer 611 and the second conductive layer 612. The non-conductive layer 621 may include a polymer material. The non-conductive layer 621 may include PI, PET, or polycarbonate (PC). Without being limited thereto, the non-conductive layer 621 may include the same material as the first support layer 601 or the second support layer 602. For example, the non-conductive layer 621 may include GFRP. The non-conductive layer 621 may operate as an insulating layer that electrically separates the first conductive layer 611 and the second conductive layer 612. The non-conductive layer 621 may be referred to as the insulating layer.

The first conductive layer 611 and the second conductive layer 612 may include a conductive pattern corresponding to at least some of the slits 434 in the deformable part 433, 504, and 505. Through the conductive pattern, the first conductive layer 611 and the second conductive layer 612 may connect the conductive portion in the planar part 431, 432, 501, 502, and 503. The first conductive layer 611 and the second conductive layer 612 may be electrically connected to a PCB (e.g., the PCB 350 of FIG. 3) through the connectors 511, 512, and 513.

Referring to FIG. 7A, a support plate 430 may further include a third conductive layer 713 and an additional non-conductive layer 722. The third conductive layer 713 may include a conductive line (or a wiring). The third conductive layer 713 may include a copper foil pattern (structure) or a copper line. The third conductive layer 713 may be electrically connected to a first PCB (e.g., the first PCB 351 of FIG. 3), a second PCB (e.g., the second PCB 352 of FIG. 3), a third PCB (e.g., the third PCB 353 of FIG. 3), a first battery (e.g., the first battery 361 of FIG. 3), a second battery (e.g., the second battery 362 of FIG. 3), or a third battery (e.g., the third battery 363 of FIG. 3) disposed in each of housings (e.g., the first housing 110, the second housing 120, or the third housing 130 of FIG. 1). The third conductive layer 713 may electrically connect electronic components disposed in the first PCB 351, the second PCB 352, or the third PCB 353 through connectors (e.g., the first connector 511, the second connector 512, and the third connector 513 of FIG. 5). The operation of the third conductive layer 713 may be the same as or similar to that of a second conductive layer 612. The third conductive layer 713 may perform some functions of the second conductive layer 612. For example, in case that the conductive line disposed on the second conductive layer 612 is insufficient, the conductive line may be disposed on the third conductive layer 713.

The additional non-conductive layer 722 may be disposed between the second conductive layer 612 and the third conductive layer 713. The non-conductive layer 621 may include a polymer material. The additional non-conductive layer 722 may include PI, PET, or PC. Without being limited thereto, the additional non-conductive layer 722 may include the same material as the first support layer 601 or the second support layer 602. For example, the additional non-conductive layer 722 may include GFRP. The additional non-conductive layer 722 may operate as an insulating layer that electrically separates the second conductive layer 612 and the third conductive layer 713. The additional non-conductive layer 722 may be referred to as the insulating layer.

Referring to FIG. 7B, the support plate 430 may further include a conductive via 730.

The conductive via 730 may connect the second conductive layer 612 and the third conductive layer 713. The conductive via 730 may penetrate the additional non-conductive layer 722. The conductive via 730 penetrating a via hole formed in the additional non-conductive layer 722 may contact the second conductive layer 612 and the third conductive layer 713. The via hole may be formed in a portion of the second conductive layer 612 and at least a portion of the third conductive layer 713. The conductive via may fill the via hole formed in the additional non-conductive layer 722, the portion of the second conductive layer 612, and the portion of the third conductive layer 713.

The conductive via 730 may extend or change a path of a signal transmitted along a conductive pattern (structure) or a conductive line (or wiring) disposed on the second conductive layer 612 to a conductive pattern (structure) or a conductive line (or wiring) disposed on the third conductive layer 713. For example, a portion of an electrical signal or power transmitted through the second conductive layer 612 may be transmitted through the third conductive layer 713 to the conductive via 730.

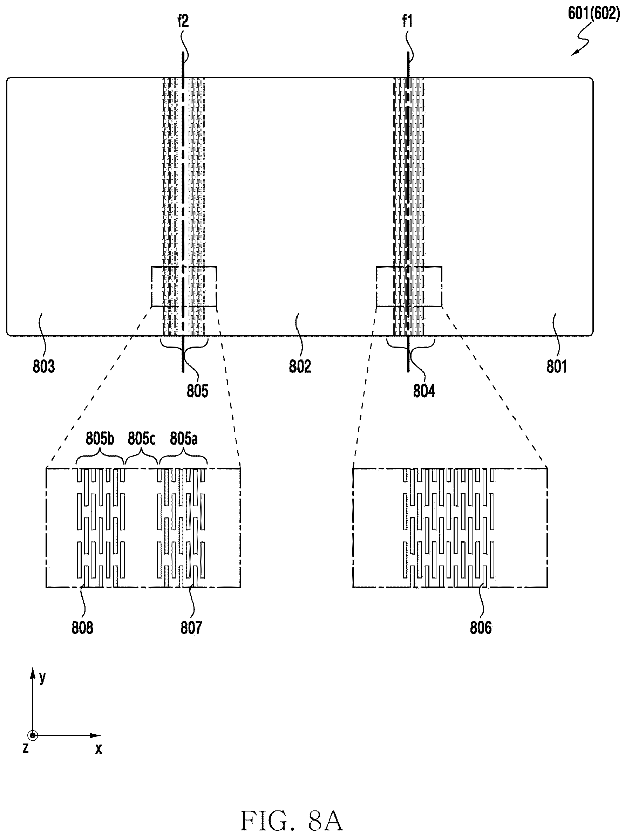

FIG. 8A is an exemplary diagram illustrating a support layer of a support plate.

Referring to FIG. 8A, support layer 601 and 602 may include rigid portions 801, 802, and 803 corresponding to a planar part (e.g., the planar part 431 and 432 of FIG. 4) of a support plate 430 and ductility portions 804 and 805 corresponding to a deformable part (e.g., the deformable part 433 of FIG. 4). The rigid portions 801, 802, and 803 may be configured to support a first display part 141 (e.g., the first display part 141 of FIG. 1), a second display part 142 (e.g., the second display part 142 of FIG. 1), and a fourth display part 144 (e.g., the fourth display part 144 of FIG. 1) maintaining a shape of a display 140 (e.g., the display 140 of FIG. 1). The ductility portions 804 and 805 may be configured to support a third display part 143 (e.g., the third display part 143 of FIG. 1) and a fifth display part 145 (e.g., the fifth display part 145 of FIG. 1) of the display 140, which are deformed according to a state of an electronic device 100. The first rigid portion 801 may support the first display part 141. The second rigid portion 802 may support the second display part 142. The third rigid portion 803 may support the third display part 143.

The first ductility portion 804 may be configured to rotate the first rigid portion 801 and the second rigid portion 802 with respect to a first folding axis f1. The second ductility portion 805 may be configured to rotate the second rigid portion 802 and the third rigid portion 803 with respect to a second folding axis f2. The first ductility portion 804 and the second ductility portion 805 may include slits 806, 807, and 808 so as to be folded around the folding axis.

The first ductility portion 804 may be disposed on a first hinge cover 153 (e.g., the first hinge cover 153 of FIG. 1) and the second ductility portion 805 may be disposed on a second hinge cover 163 (e.g., the second hinge cover 163 of FIG. 1). Since a first width w1 of a first hinge structure 150 (e.g., the first hinge structure 150 of FIG. 1) disposed under the first ductility portion 804 is narrower than a second width w2 of a second hinge structure 160 (e.g., the second hinge structure 160 of FIG. 1), a width of the first ductility portion 804 may be narrower than a width of the second ductility portion 805. The second ductility portion 805 may include deformable areas 805a and 805b and a non-deformable area 805c. The deformable areas 805a and 805b may be spaced apart from each other. The non-deformable area 805c may be disposed between the deformable areas 805a and 805b. The non-deformable area 805c may correspond to a planar portion 505a (e.g., the planar portion 505a of FIG. 5). The non-deformable area 805c may be an area in which the slits 807 and 808 are not disposed. The non-deformable area 805c may be not deformed as like the planar portion 505a, and may face a first side surface (e.g., the first side surface 111 of FIG. 1) of a first housing (e.g., the first housing 110 of FIG. 1) in a folding state 102.

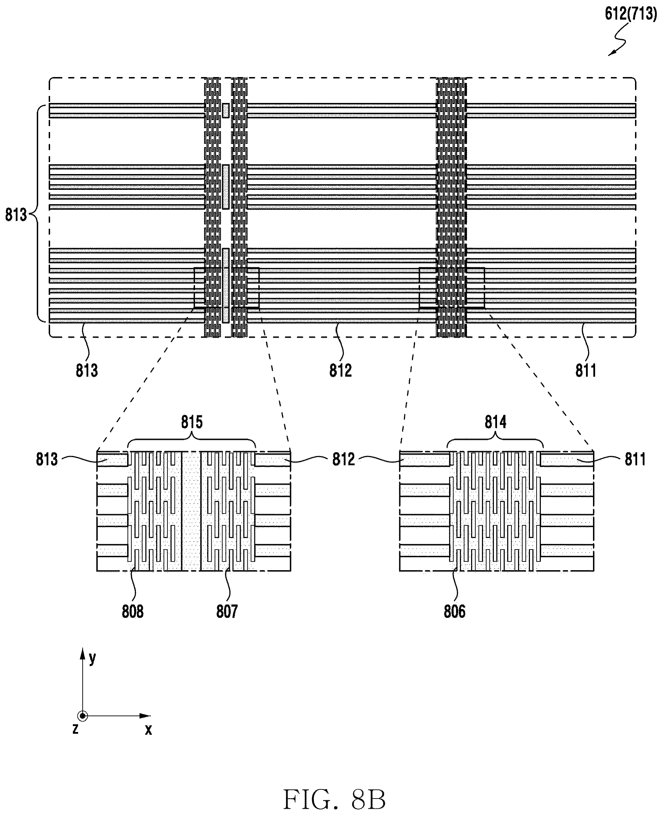

FIG. 8B is an exemplary diagram illustrating a conductive layer forming a signal wiring in a support plate.

Referring to FIG. 8B, a second conductive layer 612 (e.g., the second conductive layer 612 or a third conductive layer 713 of FIG. 7A or 7B) may include conductive lines 810 and conductive patterns (structures) 814 and 815.

The second conductive layer 612 may be surrounded by support layers 601 and 602. First conductive lines 811 may be surrounded by a first rigid portion 801 of the first support layer 601 and the second support layer 602. Second conductive lines 812 may be surrounded by a second rigid portion 802 of the first support layer 601 and the second support layer 602. Third conductive lines 813 may be surrounded by a third rigid portion 803 of the first support layer 601 and the second support layer 602. The first conductive lines 811, the second conductive lines 812, and the third conductive lines 813 may maintain a shape even when a state of an electronic device 100 changes by being surrounded by the rigid portions 801, 802, and 803.

The first conductive pattern 814 may be surrounded by a first ductility portion 804 of the first support layer 601 and the second support layer 602. The second conductive pattern 815 may be surrounded by a second ductility portion 805 of the first support layer 601 and the second support layer 602. The first conductive pattern 814 and the second conductive pattern 815 may change according to a change in the state of the electronic device 100 by being surrounded by the ductility portions 804 and 805. The first conductive pattern 814 and the second conductive pattern 815 may be unfolded in an un-folding state 101 of the electronic device 100, and may be folded in a folding state 102 of the electronic device 100. The first conductive pattern 814 and the second conductive pattern 815 may be disposed between slits 434. For example, the first conductive pattern 814 and the second conductive pattern 815 may extend along a periphery of the slits 434. For another example, the first conductive pattern 814 and the second conductive pattern 815 may extend in the same shape as the conductive lines 811, 812, and 813, and may include openings corresponding to slits 434, 806, 807, and 808.

The first conductive pattern 814 may include the slits in an area corresponding to the first ductility portion 804, or may extend along the slits 806. For example, conductive patterns 815a and 815b in an area corresponding to deformable areas 805a and 805b of the second conductive patterns 815 may include the slits in the second ductility portion 805, or may extend along the slits 807 and 808. A conductive pattern 815c in an area corresponding to a non-deformable area 805c of the second conductive pattern 815 may not include the slits. The conductive pattern 815c at a portion surrounded by the non-deformable area 805c may be similar to the conductive lines 811, 812, and 813.

The first conductive pattern 814 may connect the first conductive lines 811 and the second conductive lines 812. The second conductive pattern 815 may connect the second conductive lines 812 and the third conductive lines 813.

The second conductive layer 612 may connect electronic components disposed in each housing to each other through the first conductive lines 811, the second conductive lines 812, the third conductive lines 813, the first conductive pattern 814, and the second conductive pattern 815.

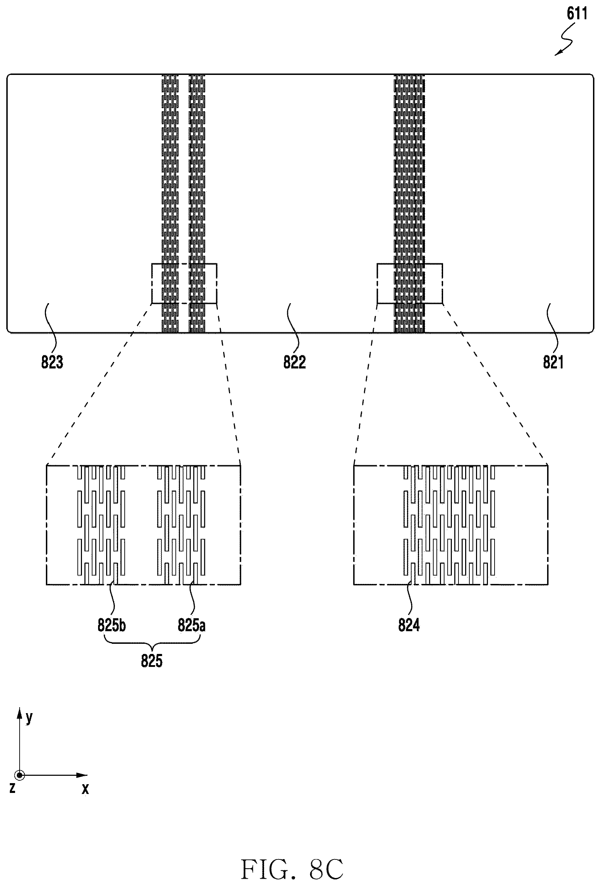

FIG. 8C is an exemplary diagram illustrating a conductive layer forming a ground in a support plate.

Referring to FIG. 8C, a first conductive layer 611 (e.g., the first conductive layer 611 of FIG. 6) may include rigid portions 821, 822, and 823 corresponding to a planar part (e.g., the planar part 431 and 432 of FIG. 4) of a support plate 430 and ductility portions 824 and 825 corresponding to a deformable part (e.g., the deformable part 433 of FIG. 4).

In the ductility portions 824 and 825, the first conductive pattern 814 and the second conductive pattern 815 of FIG. 8b may have a same or similar conductive pattern. The ductility portions 824 and 825 may include slits, or may extend along slits 806, 807, and 808 of support layers 601 and 602.

The first conductive layer 611 may cover a second conductive layer 612. For example, when the support plate 430 is viewed vertically, the second conductive layer 612 may completely overlap the first conductive layer 611 (e.g., the first conductive layer 611). The first conductive layer 611 covering the second conductive layer 612 may operate as a ground layer. The first conductive layer 611 covering the second conductive layer 612 may reduce distortion or interference of a signal transmitted along the second conductive layer 612.

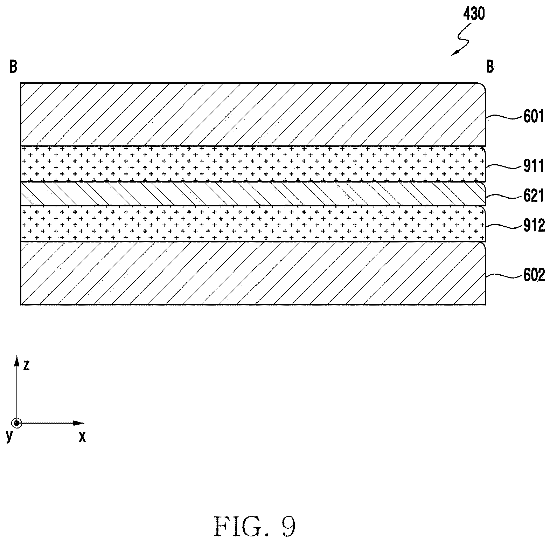

FIG. 9 is a cross-sectional view of an exemplary support plate including conductive layers having a conductive pattern.

FIG. 9 is a cross-sectional view (e.g., a cross-sectional view cut along B-B of FIG. 5) in which an exemplary support plate 430 of a display 140 is cut.

Referring to FIG. 9, the support plate 430 may include a first support layer 601, a second support layer 602, a first conductive layer 911, a second conductive layer 912, and/or a non-conductive layer 621. At least one of components of the support plate 430 may be the same as or similar to at least one of the components of the support plate 430 of FIG. 6, and overlapping descriptions will be omitted below.

The first support layer 601 and the second support layer 602 may include a substantially non-conductive material. The first support layer 601 and the second support layer 602 may include a glass fiber reinforced plastic (GFRP). The first support layer 601 may form a surface of the support plate 430 facing a superstructure 400a (e.g., the display superstructure 400a of FIG. 4) of the display. The first support layer 601 may be in contact with the display superstructure 400a.

The first conductive layer 911 and the second conductive layer 912 may include conductive patterns (structures). The conductive patterns (structures) may be conductive lines parallel to each other. The first conductive layer 911 and the second conductive layer 912 may include a copper foil pattern (structure) or a copper line. The first conductive layer 911 and the second conductive layer 912 may be configured to receive an external input. For example, the first conductive layer 911 and the second conductive layer 912 may be configured to identify the external input through electromagnetically interacting with an external object. The first conductive layer 911 and the second conductive layer 912 may be a digitizer.

The non-conductive layer 621 may be disposed between the first conductive layer 911 and the second conductive layer 912. The non-conductive layer 621 may include a polymer material. The non-conductive layer 621 may include GFRP. The non-conductive layer 621 may operate as an insulating layer that electrically separates the first conductive layer 911 and the second conductive layer 912. The non-conductive layer 621 may be referred to as the insulating layer.

The first conductive layer 911 and the second conductive layer 912 may include a conductive pattern corresponding to at least some of slits 434 in a deformable part 433, 504, and 505. Through the conductive pattern, the first conductive layer 911 and the second conductive layer 912 may connect a conductive portion in a planar part 431, 432, 501, 502, and 503.

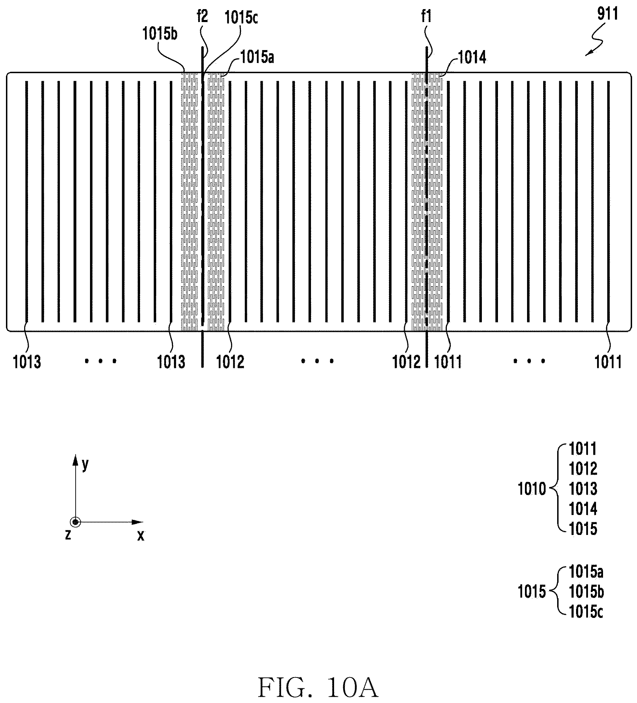

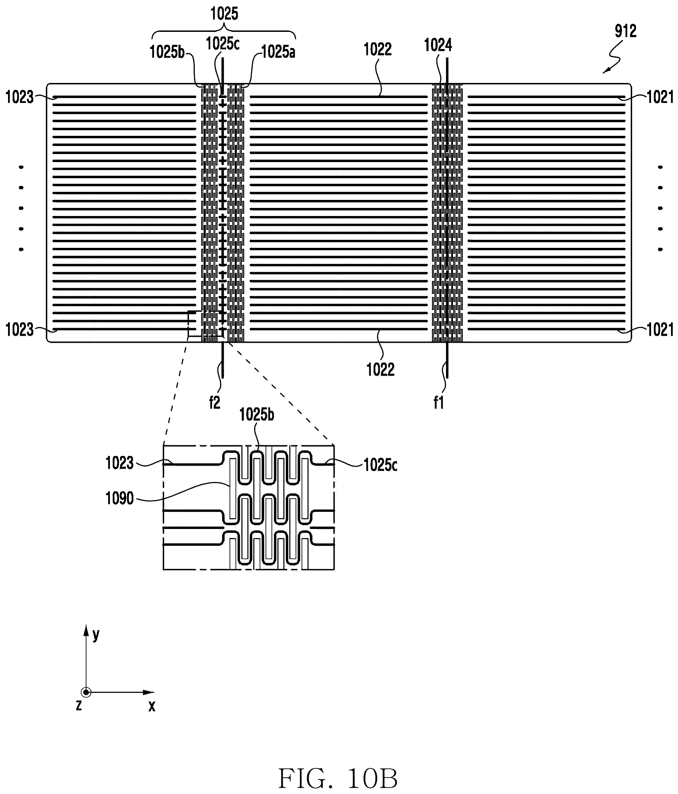

The configuration of the first conductive layer 911 and the second conductive layer 912 will be described referring to FIGS. 10A and 10B.

FIG. 10A is an exemplary diagram illustrating a first conductive layer having a conductive pattern (structure) extending in a first direction. FIG. 10B is an exemplary diagram illustrating a second conductive layer having a conductive pattern (structure) extending in a second direction.

A first conductive layer 911 and a second conductive layer 912 may be surrounded by support layers 601 and 602. The first conductive layer 911 and the second conductive layer 912 may be separated by a non-conductive layer 621.

Referring to FIG. 10A, the first conductive layer 911 may include a set 1010 of a plurality of first conductive patterns (structures) extending in a direction parallel to a first folding axis f1 and a second folding axis f2. The set 1010 of the plurality of first conductive patterns (structures) may be in contact with the first support layer 601.

Among the first conductive layer 911, conductive patterns (structures) 1011 disposed in an area corresponding to a first planar part 501 of a support plate 430 may be in contact with a first rigid portion 801 (e.g., the first rigid portion 801 of FIG. 8A) of the first support layer 601. Among the first conductive layer 911, conductive patterns (structures) 1012 disposed in an area corresponding to a second planar part 502 of the support plate 430 may be in contact with a second rigid portion 802 (e.g., the second rigid portion 802 of FIG. 8A) of the first support layer 601. Among the first conductive layer 911, conductive patterns (structures) 1013 disposed in an area corresponding to a third planar part 503 of the support plate 430 may be in contact with a third rigid portion 803 (e.g., the third rigid portion 803 of FIG. 8A) of the first support layer 601. The conductive patterns (structures) 1011, 1012, and 1013 may maintain a shape even when a state of an electronic device 100 changes by being surrounded by the rigid portions 801, 802, and 803.

A first connection pattern 1014 may be in contact with a first ductility portion 804 (e.g., the first ductility portion 804 of FIG. 8A) of the first support layer 601. A second connection pattern 1015 may be in contact with a second ductility portion 805 (e.g., the second ductility portion 805 of FIG. 8A) of the first support layer 601. The first connection pattern 1014 and the second connection pattern 1015 may change according to a change in the state of the electronic device 100 by being surrounded by the ductility portions 804 and 805.

The first connection pattern 1014 may connect the conductive patterns (structures) 1011 disposed in the area corresponding to the first planar part 501 and the conductive patterns (structures) 1012 disposed in an area corresponding to the second planar part 502 to each other. The second connection pattern 1015 may connect the conductive patterns (structures) 1012 disposed in an area corresponding to the second planar part 502 and the conductive patterns (structures) 1013 disposed in an area corresponding to the third planar part 503 to each other.

The conductive patterns (structures) 1011 disposed in an area corresponding to the first planar part 501 may be connected to each other. For example, the conductive patterns (structures) 1011 may be connected to each other at the ends or may be connected to each other in the middle of the conductive patterns (structures) 1011. The conductive patterns (structures) 1012 disposed in an area corresponding to the second planar part 502 may be connected to each other. The conductive patterns (structures) 1013 disposed in an area corresponding to the third planar part 503 may be connected to each other.

The first connection pattern 1014 may be connected to a pattern (structure) 1011a adjacent to the first connection pattern 1014 among the conductive patterns (structures) 1011 disposed in the area corresponding to the first planar part 501 and a pattern (structure) 1012a adjacent to the first connection pattern 1014 among the conductive patterns (structures) 1012 disposed in the area corresponding to the second planar part 502. The second connection pattern 1015 may be connected to a pattern (structure) 1012b adjacent to the second connection pattern 1015 among the conductive patterns (structures) 1012 disposed in the area corresponding to the second planar part 502 and a pattern (structure) 1013a adjacent to the second connection pattern 1015 among the conductive patterns (structures) 1013 disposed in the area corresponding to the third planar part 503.

The second connection pattern 1015 may include slits in an area corresponding to the second ductility portion 805 of the support layers 601 and 602, or may extend along slits 806. For example, connection patterns 1015a and 1015b in an area corresponding to deformable areas 805a and 805b among the second connection patterns 1015 may include the slits in the second ductility portion 805 or may extend along slits 1016. A connection pattern 1015c in an area corresponding to a non-deformable area 805c of the second connection pattern 1015 may not include the slits. The connection pattern 1015c in the area corresponding to the non-deformable area 805c may extend in a direction parallel to the folding axes f1 and f2, as like the conductive patterns (structures) 1011, 1012, and 1013. The set 1010 of the first conductive patterns (structures) of the first conductive layer 911 may operate as an electrode in a vertical direction (e.g., a folding axis direction) of an electromagnetic field induction panel.

Referring to FIG. 10B, the second conductive layer 912 may include a set 1020 of a plurality of second conductive patterns (structures) extending in a direction perpendicular to the first folding axis f1 and the second folding axis f2. The second conductive layer 912 may include the set 1020 of the second conductive patterns(structures), a first connection pattern 1024, and a second connection pattern 1025.

The second conductive layer 912 may be disposed under the first support layer 601. Among the second conductive layer 912, conductive patterns (structures) 1021 disposed in the area corresponding to the first planar part 501 of the support plate 430 may be surrounded by the first rigid portion 801 of the first support layer 601 and the second support layer 602. Among the second conductive layer 912, conductive patterns (structures) 1022 disposed in the area corresponding to the second planar part 502 of the support plate 430 may be surrounded by the second rigid portion 802 of the first support layer 601 and the second support layer 602. Among the second conductive layer 912, conductive patterns (structures) 1023 disposed in the area corresponding to the third planar part 503 of the support plate 430 may be surrounded by the third rigid portion 803 of the first support layer 601 and the second support layer 602. Among the second conductive layer 912, the conductive patterns (structures) 1021, 1022, and 1023 disposed in the area corresponding to the first planar part 501, the second planar part 502, and the third planar part 503 of the support plate 430 may maintain a shape even when the state of the electronic device 100 changes by being surrounded by the rigid portions 801, 802, and 803.

The third connection pattern 1024 may be disposed under the first ductility portion 804 (e.g., the first ductility portion 804 of FIG. 8A) of the first support layer 601. The fourth connection pattern 1025 may be disposed under the second ductility portion 805 (e.g., the second ductility portion 805 of FIG. 8A) of the first support layer 601. The third connection pattern 1024 and the fourth connection pattern 1025 may change according to a change in the state of the electronic device 100 by being surrounded by the ductility portions 804 and 805.

The third connection pattern 1024 may be surrounded by the first ductility portion 804 of the first support layer 601 and the second support layer 602. The fourth connection pattern 1025 may be surrounded by the second ductility portion 805 of the first support layer 601 and the second support layer 602. The first connection pattern 1024 and the fourth connection pattern 1025 may change according to a change in the state of the electronic device 100 by being surrounded by the ductility portions 804 and 805. The third connection pattern 1024 and the fourth connection pattern 1025 may extend between slits 1090. For example, the third connection pattern 1024 and the fourth connection pattern 1025 may extend along a periphery of the slits 1090. For example, among the second conductive layer 912, the conductive patterns (structures) 1023 disposed in the area corresponding to the third planar part 503 of the support plate 430 may be connected to a pattern 1025b in the area corresponding to the deformable area 805b among the second connection pattern 1025. The pattern 1025b may extend along the slits 1090 in a shape of a meander line. A pattern 1025a may extent along the slits 1090 similarly to the pattern 1025b, and be connected to the conductive patterns (structures) 1022 disposed in the area corresponding to the second planar part 502 of the support plate 430 among the second conductive layer 912.

Among the fourth connection pattern 1025, a pattern 1025c in the area corresponding to the non-deformable area 805c may extend in a direction perpendicular to the folding axes f1 and f2, similar to the conductive patterns (structures) 1021, 1022, and 1023.

The third connection pattern 1024 may connect the conductive patterns (structures) 1021 disposed in the area corresponding to the first planar part 501 of the support plate 430 among the second conductive layer 912 and the conductive patterns (structures) 1022 disposed in the area corresponding to the second planar part 502 of the support plate 430 among the second conductive layer 912. The second conductive pattern 1025 may connect the conductive patterns 1022 (structures) disposed in the area corresponding to the second planar part 502 of the support plate 430 among the second conductive layer 912 and the conductive patterns 1023 (structures) disposed in the area corresponding to the third planar part 503 of the support plate 430 among the second conductive layer 912.

The set 1010 of the first conductive patterns(structures) of the first conductive layer 911 may operate as an electrode in a horizontal direction (e.g., a direction perpendicular to the folding axis) of the electromagnetic field induction panel.

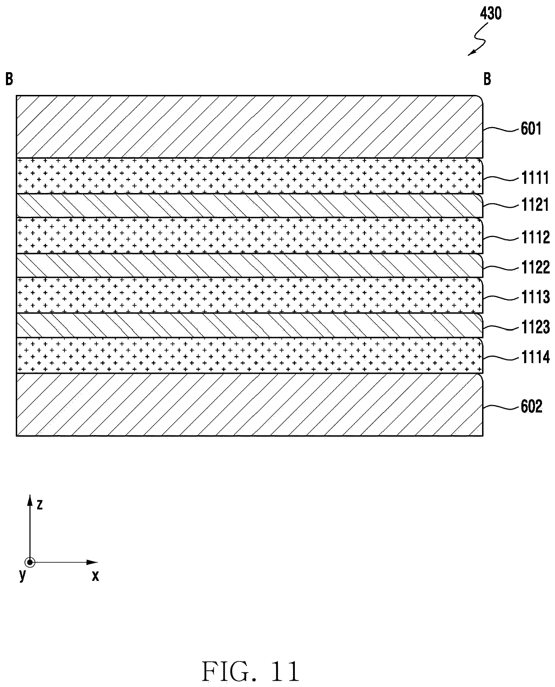

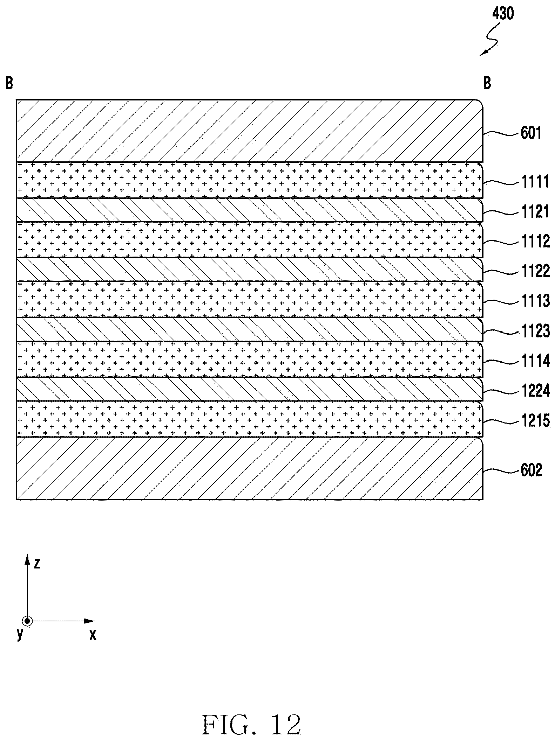

FIG. 11 is a cross-sectional view of an exemplary support plate including conductive layers having a conductive pattern (structures) and conductive layers having wirings. FIG. 12 is a cross-sectional view of an exemplary support plate further including a conductive layer having additional wirings.

FIGS. 11 and 12 are cross-sectional views (e.g., cross-sectional views cut along B-B of FIG. 5) in which an exemplary support plate 430 of a display 140 is cut.

Referring to FIG. 11, the support plate 430 may include a first support layer 601, a second support layer 602, a first conductive layer 1111, a second conductive layer 1112, a third conductive layer 1113, a fourth conductive layer 1114, a first non-conductive layer 1121, a second non-conductive layer 1122, and/or a third non-conductive layer 1123. At least one of the components of the support plate 430 may be the same as or similar to at least one of the components of the support plate 430 of FIGS. 6, 7A, 7B, and 9, and overlapping descriptions will be omitted below.

The first support layer 601 and the second support layer 602 may include a substantially non-conductive material. The first support layer 601 and the second support layer 602 may include a glass fiber reinforced plastic (GFRP). The first support layer 601 may form a surface of the support plate 430 facing a superstructure 400a (e.g., the display superstructure 400a of FIG. 4) of the display. The first support layer 601 may be in contact with the display superstructure 400a.

The first conductive layer 1111 (e.g., the first conductive layer 911 of FIG. 9) and the second conductive layer 1112 (e.g., the second conductive layer 912) may include conductive patterns (structures). The conductive patterns (structures) may be conductive lines parallel to each other. For example, the conductive patterns (structures) disposed on the first conductive layer 1111 may extend in a direction parallel to a folding axis (e.g., the first folding axis f1 or the second folding axis f2). The conductive patterns (structures) disposed on the second conductive layer 1112 may extend in a direction perpendicular to the folding axis. The first conductive layer 1111 and the second conductive layer 1112 may include a copper foil pattern or a copper line. The first conductive layer 1111 and the second conductive layer 1112 may be configured to receive an external input. For example, the first conductive layer 1111 and the second conductive layer 1112 may operate as a digitizer by being configured to identify the external input through electromagnetically interacting with an external object.

The first conductive layer 1111 and the second conductive layer 1112 may include a conductive pattern corresponding to at least some of slits 434, 806, 807, and 808 in a deformable part 433, 504, and 505. Through the conductive pattern, the first conductive layer 1111 and the second conductive layer 1112 may connect conductive portions in a planar part 431, 432, 501, 502, and 503.

The first conductive layer 1111 and the second conductive layer 1112 may be the same as or similar to the first conductive layer 911 and the second conductive layer 912 of FIG. 9.

The third conductive layer 1113 (e.g., the first conductive layer 611 of FIG. 6) may include a conductive film. The third conductive layer 1113 may be electrically connected to a conductive portion (e.g., the metal portion in the electronic device 100, the housings 110, 120, and 130, or support members 311, 321, and 331) disposed in the electronic device 100. The third conductive layer 1113 may operate as a ground layer or a ground. The third conductive layer 1113 may include a metal film (e.g., copper foil).

The fourth conductive layer 1114 (e.g., the second conductive layer 612 of FIG. 6) may include a conductive line (or wiring). The fourth conductive layer 1114 may include a copper foil pattern or a copper line. The fourth conductive layer 1114 may be electrically connected to a first PCB (e.g., the first PCB 351 of FIG. 3), a second PCB (e.g., the second PCB 352 of FIG. 3), a third PCB (e.g., the third PCB 353 of FIG. 3), a first battery (e.g., the first battery 361 of FIG. 3), a second battery (e.g., the second battery 362 of FIG. 3), or a third battery (e.g., the third battery 363 of FIG. 3) disposed on each of housings (e.g., the first housing 110, the second housing 120, or the third housing 130 of FIG. 1). The fourth conductive layer 1114 may electrically connect electronic components disposed in the first PCB 351, the second PCB 352, or the third PCB 353 through connectors (e.g., the first connector 511, the second connector 512, and the third connector 513 of FIG. 5).

The third conductive layer 1113 and the fourth conductive layer 1114 may include a conductive pattern corresponding to at least some of the slits 434 in the deformable part 433, 504, and 505. Through the conductive pattern, the third conductive layer 1113 and the fourth conductive layer 1114 may connect the conductive portion in the planar part 431, 432, 501, 502, and 503. The third conductive layer 1113 and the fourth conductive layer 1114 may be electrically connected to a PCB (e.g., the PCB 350 of FIG. 3) through the connectors 511, 512, and 513.

The third conductive layer 1113 and the fourth conductive layer 1114 may be the same as or similar to the first conductive layer 611 and the second conductive layer 612 of FIG. 6.

The first non-conductive layer 1121 may be disposed between the first conductive layer 1111 and the second conductive layer 1112. The first non-conductive layer 1121 may operate as an insulating layer that electrically separates the first conductive layer 1111 and the second conductive layer 1112.

The second non-conductive layer 1122 may be disposed between the second conductive layer 1112 and the third conductive layer 1113. The second non-conductive layer 1122 may operate as an insulating layer that electrically separates the second conductive layer 1112 and the third conductive layer 1113.

The third non-conductive layer 1123 may be disposed between the third conductive layer 1113 and the fourth conductive layer 1114. The third non-conductive layer 1123 may operate as an insulating layer that electrically separates the third conductive layer 1113 from the fourth conductive layer 1114. The non-conductive layers 1121, 1122, and 1123 may be referred to as the insulating layer in terms of electrically separating the conductive layer.

The first non-conductive layer 1121, the second non-conductive layer 1122, and the third non-conductive layer 1123 may include a polymer material. The first non-conductive layer 1121, the second non-conductive layer 1122, and the third non-conductive layer 1123 may include GFRP.

Referring to FIG. 12, the support plate 430 may further include a fifth conductive layer 1215 and a fourth non-conductive layer 1224.

The fifth conductive layer 1215 (e.g., the second conductive layer 612 of FIG. 6) may include a conductive line (or wiring). The fifth conductive layer 1215 may include a copper foil pattern or a copper line. The fifth conductive layer 1215 may be electrically connected to the first PCB 351, the second PCB 352, the third PCB 353, the first battery 361, the second battery 362, or the third battery 363 disposed on each of the housings 110, 120, and 130. The fifth conductive layer 1215 may electrically connect electronic components disposed in the first PCB 351, the second PCB 352, or the third PCB 353 through the connectors 511, 512, and 513.

The configuration and operation of the fifth conductive layer 1215 may be the same as or similar to that of the fourth conductive layer 1214. The fifth conductive layer 1215 may perform some functions of the fourth conductive layer 1214. For example, in case that the conductive line disposed on the fourth conductive layer 1214 is insufficient, the conductive line may be disposed on the fifth conductive layer 1215.

The fourth non-conductive layer 1224 may be disposed between the fourth conductive layer 1114 and the fifth conductive layer 1215. The fourth non-conductive layer 1224 may include a polymer material. The fourth non-conductive layer 1224 may include PI, PET, or PC. Without being limited thereto, the fourth non-conductive layer 1224 may include the same material as the first support layer 601 or the second support layer 602. For example, the fourth non-conductive layer 1224 may include GFRP. The fourth non-conductive layer 1224 may operate as an insulating layer that electrically separates the fourth conductive layer 1114 and the fifth conductive layer 1215. The fourth non-conductive layer 1224 may be referred to as the insulating layer.

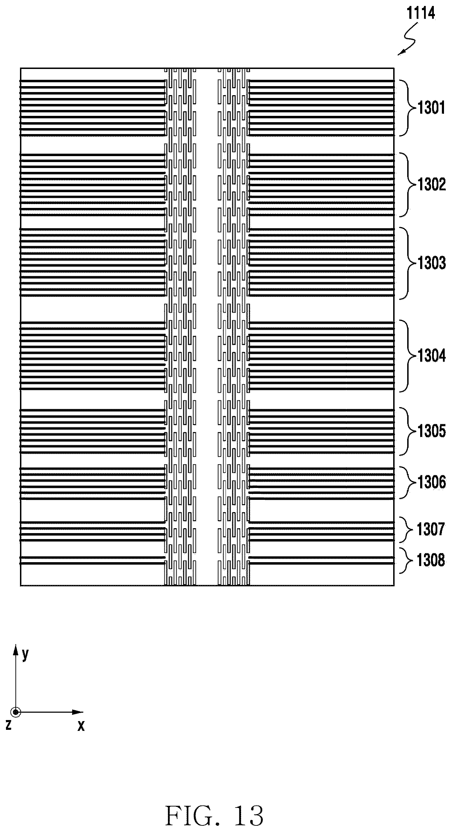

FIG. 13 is a diagram illustrating an exemplary disposition of a wiring formed in a conductive layer.

Referring to FIG. 13, a fourth conductive layer 1114 (e.g., the fourth conductive layer 1114 of FIG. 11) may be electrically connected to a first PCB 351, a second PCB 352, a third PCB 353, a first battery 361, a second battery 362, or a third battery 363 disposed on each of housings 110, 120, and 130.

The fourth conductive layer 1114 may include a plurality of conductive lines 1301, 1302, 1303, 1304, 1305, 1306, 1307, and 1308. In FIG. 13, the conductive lines disposed on the fourth conductive layer 1114 are exemplarily illustrated.

The plurality of conductive lines 1301, 1302, 1303, 1304, 1305, 1306, 1307, and 1308 may be grouped and disposed according to functions. A set 1301 of first conductive lines may be conductive lines for a display (e.g., the display 373 of FIG. 3) and a camera disposed under a display 140. A set 1302 of second conductive lines may be conductive lines for a camera disposed under the display 373 and a high-speed communication line. A set 1303 of third conductive lines may be conductive lines for a camera configured to obtain an image through a rear camera (e.g., a rear camera disposed on the second rear cover 372 of FIG. 3) and conductive lines connected to a connector for a touch sensor panel (TSP) in a display panel (e.g., the display panel 401 of FIG. 4) and a display (e.g., the display 140 of FIG. 1). The set 1304 of fourth conductive lines may be conductive lines for connectors and sensors for the rear camera and cameras disposed under the display. The set 1305 of fifth conductive lines may be conductive lines for a connector, speaker, battery, and side key for connection with a wireless communication module. The sixth conductive lines 1306, the seventh conductive lines 1307, and the eighth conductive lines 1308 may be lines for transmitting power to an electronic component in an electronic device 100.

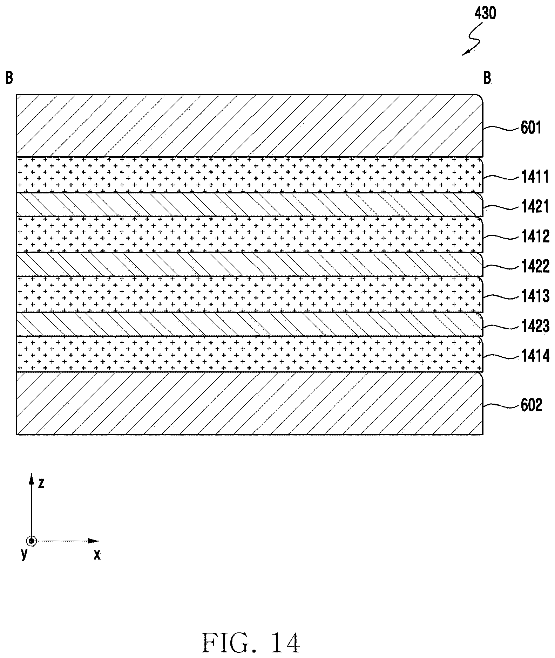

FIG. 14 is a cross-sectional view of an exemplary support plate including a conductive layer including differential wirings.

FIG. 14 is a cross-sectional view (e.g., a cross-sectional view cut along B-B of FIG. 5) in which an exemplary support plate 430 of a display 140 is cut. Referring to FIG. 14, the support plate 430 may include a first support layer 601, a second support layer 602, a first conductive layer 1411, a second conductive layer 1412, a third conductive layer 1413, a fourth conductive layer 1414, a first non-conductive layer 1421, a second non-conductive layer 1422, and/or a third non-conductive layer 1423. At least one of the components of the support plate 430 may be the same as or similar to at least one of the components of the support plate 430 of FIGS. 6, 7A, 7B, 9, 11, and 12, and overlapping descriptions will be omitted below.

The first support layer 601 and the second support layer 602 may include a substantially non-conductive material. The first support layer 601 and the second support layer 602 may include GFRP. The first support layer 601 may form a surface of the support plate 430 facing a superstructure 400a (e.g., the display superstructure 400a of FIG. 4) of the display. The first support layer 601 may be in contact with the display superstructure 400a.

The first conductive layer 1411 (e.g., the first conductive layer 911 of FIG. 9, the first conductive layer 1111 of FIG. 11), and the second conductive layer 1412 (e.g., the second conductive layer 912 of FIG. 9 or the second conductive layer 1112 of FIG. 11) may include conductive patterns (structures). The conductive patterns (structures) may be conductive lines parallel to each other. For example, the conductive patterns (structures) disposed on the first conductive layer 1411 may extend in a direction parallel to a folding axis (e.g., the first folding axis f1 or the second folding axis f2). The conductive patterns (structures) disposed on the second conductive layer 1412 may extend in a direction perpendicular to the folding axis. The first conductive layer 1411 and the second conductive layer 1412 may include a copper foil pattern or a copper line. The first conductive layer 1411 and the second conductive layer 1412 may be configured to receive an external input. For example, the first conductive layer 1411 and the second conductive layer 1412 may operate as a digitizer by being configured to identify the external input through electromagnetically interacting with an external object.

The first conductive layer 1411 and the second conductive layer 1412 may include a conductive pattern corresponding to at least some of slits 434, 806, 807, and 808 in a deformable part 433, 504, and 505. Through the conductive pattern, the first conductive layer 1411 and the second conductive layer 1412 may connect conductive portions in a planar part 431, 432, 501, 502, and 503.

The first conductive layer 1411 and the second conductive layer 1412 may be the same as or similar to the first conductive layer 911 and the second conductive layer 912 of FIG. 9, or the first conductive layer 1111 and the second conductive layer 1112 of FIG. 11.

The third conductive layer 1413 may include a conductive line (or wiring). The third conductive layer 1413 may include a copper foil pattern or a copper line. The third conductive layer 1413 may be electrically connected to components (e.g., processor or DDI) for processing high-speed data in a first PCB (e.g., the first PCB 351 of FIG. 3), a second PCB (e.g., the second PCB 352 of FIG. 3), a third PCB (e.g., the third PCB 353 of FIG. 3) disposed on each of housings (e.g., the first housing 110, the second housing 120, or the third housing 130 of FIG. 1). The third conductive layer 1413 may electrically connect electronic components disposed in the first PCB 351, the second PCB 352, or the third PCB 353 through connectors (e.g., the first connector 511, the second connector 512, and the third connector 513 of FIG. 5). The third conductive layer 1413 may comprise a differential line. The third conductive layer 1413 may include at least one pair of conductive lines for comprising the differential line.

The fourth conductive layer 1414 (e.g., the first conductive layer 611 of FIG. 6 or the third conductive layer 1113 of FIG. 11) may include a conductive film. The fourth conductive layer 1414 may be electrically connected to a conductive portion (e.g., the metal portion, the housings 110, 120, and 130, or support members 311, 321, and 331 in the electronic device 100) disposed in the electronic device 100. The fourth conductive layer 1414 may operate as a ground layer or a ground. The fourth conductive layer 1414 may include a metal film (e.g., copper foil).

The fourth conductive layer 1414 may include a conductive pattern corresponding to at least some of the slits 434 in the deformable part 433, 504, and 505. Through the conductive pattern, the fourth conductive layer 1414 may connect the conductive portion in the planar part 431, 432, 501, 502, and 503. The fourth conductive layer 1414 may be electrically connected to a PCB (e.g., the PCB 350 of FIG. 3) through the connectors 511, 512, and 513.

The first non-conductive layer 1421 may be disposed between the first conductive layer 1411 and the second conductive layer 1412. The first non-conductive layer 1421 may operate as an insulating layer that electrically separates the first conductive layer 1411 and the second conductive layer 1412.

The second non-conductive layer 1422 may be disposed between the second conductive layer 1412 and the third conductive layer 1413. The second non-conductive layer 1422 may operate as an insulating layer that electrically separates the second conductive layer 1412 and the third conductive layer 1413.

The third non-conductive layer 1423 may be disposed between the third conductive layer 1413 and the fourth conductive layer 1414. The third non-conductive layer 1423 may operate as an insulating layer that electrically separates the third conductive layer 1413 and the fourth conductive layer 1414. The non-conductive layers 1421, 1422, and 1423 may be referred to as the insulating layer in terms of electrically separating the conductive layer. The first non-conductive layer 1421, the second non-conductive layer 1422, and the third non-conductive layer 1423 may include a polymer material. The first non-conductive layer 1421, the second non-conductive layer 1422, and the third non-conductive layer 1423 may include GFRP.

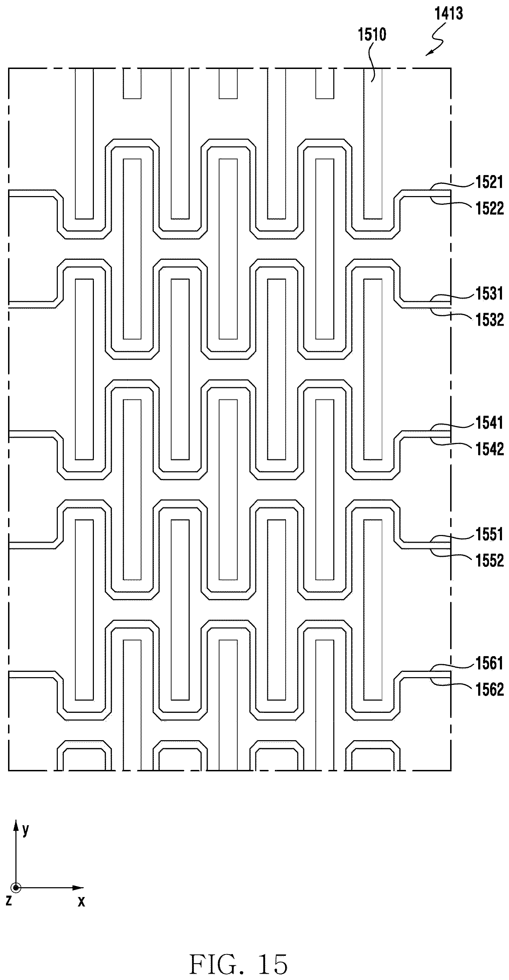

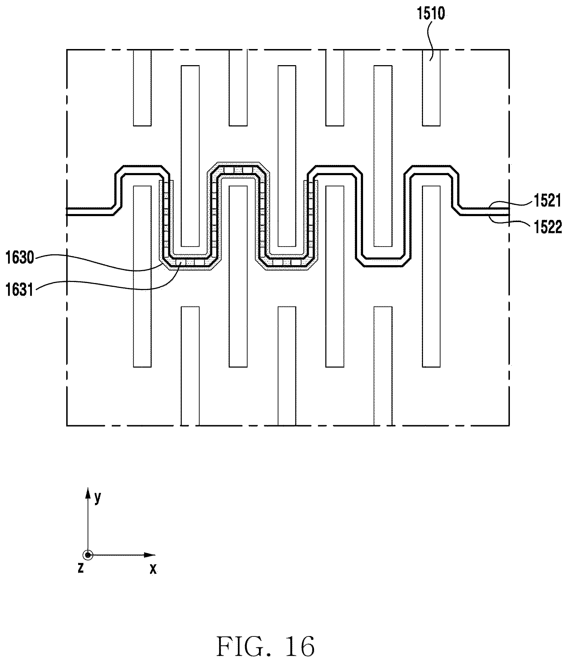

FIG. 15 is a diagram illustrating an exemplary disposition of a differential wiring disposed in a deformable area. FIG. 16 is a diagram illustrating a ground line disposed in the deformable area.

Referring to FIG. 15, a third conductive layer 1413 may include a plurality of conductive lines 1521, 1522, 1531, 1532, 1541, 1542, 1551, 1552, 1561, and 1562. In a deformable part 433 of a support plate 430, each of a plurality of pairs of conductive lines composing the third conductive layer 1413 may extend between slits 1510. For example, a pair of conductive lines 1521 and 1522 may extend along a periphery of slits 1090. For example, the pair of conductive lines 1521 and 1522 may extend meanderingly along the slits 1090 in a shape of a meander line.

Referring to FIG. 16, a conductive pattern 1630 disposed on a fourth conductive layer 1414 disposed under the third conductive layer 1413 may extend along the pair of conductive lines 1521 and 1522. The conductive pattern 1630 may also extend meanderingly along the slits 1090 in the shape of the meander line.

The conductive pattern 1630 composing the fourth conductive layer 1414 may overlap the pair of conductive lines 1521 and 1522 when a support plate (e.g., the support plate 430 of FIG. 4) is viewed from above. The conductive pattern 1630 composing the fourth conductive layer 1414 may be a line for grounding. The conductive pattern 1630 composing the fourth conductive layer 1414 may include a plurality of openings 1631. The plurality of openings 1631 may be repeatedly formed along the conductive pattern 1630. The plurality of openings 1631 may be formed not only in the deformable part 433 but also in the conductive pattern 1630 located in planar parts (e.g., the planar parts 431 and 432 of FIG. 4). The plurality of openings 1631 may be formed for impedance matching of the pair of conductive lines 1521 and 1522.

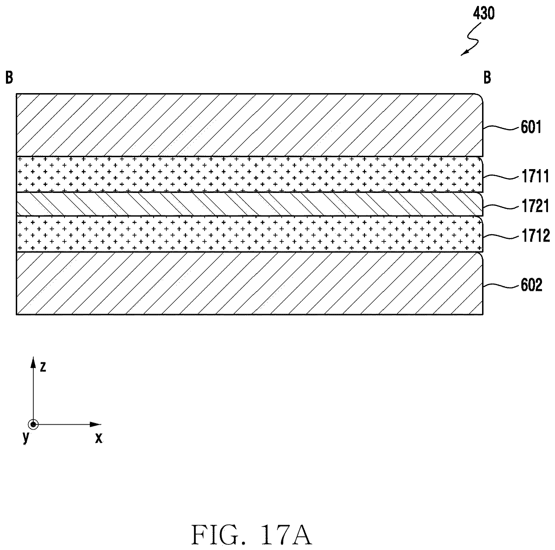

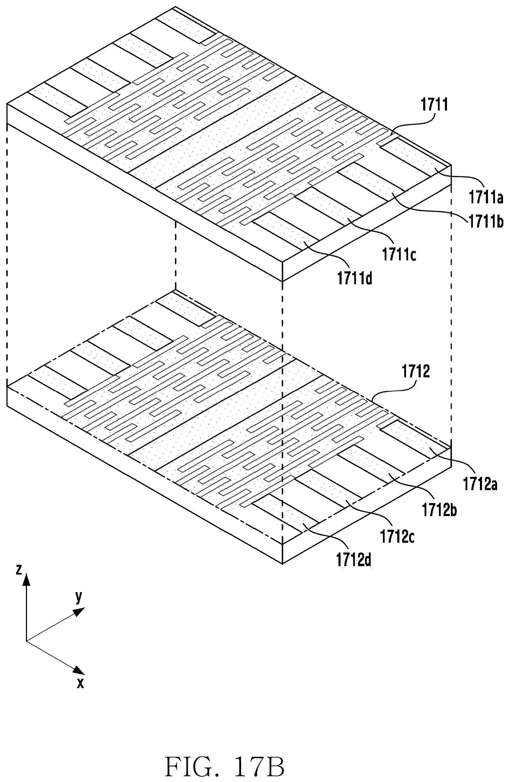

FIG. 17A is a cross-sectional view of an exemplary support plate including a plurality of layers including a power wiring. FIG. 17B is a diagram illustrating a disposition of an exemplary power wiring included in a plurality of layers.

FIG. 17A is a cross-sectional view (e.g., a cross-sectional view cut along B-B of FIG. 5) in which an exemplary support plate 430 of a display 140 is cut. Referring to FIGS. 17A and 17B, the support plate 430 may include a first support layer 601, a second support layer 602, a first conductive layer 1711, a second conductive layer 1712, and a non-conductive layer 1721. At least one of the components of the support plate 430 may be the same as or similar to at least one of the components of the support plate 430 of FIGS. 6, 7A, 7B, 9, 11, 12, and 14, and overlapping descriptions will be omitted below.

The first support layer 601 and the second support layer 602 may include a substantially non-conductive material. The first support layer 601 and the second support layer 602 may include a glass fiber reinforced plastic (GFRP). The first support layer 601 may form a surface of the support plate 430 facing a superstructure 400a (e.g., the display superstructure 400a of FIG. 4) of the display. The first support layer 601 may be in contact with the display superstructure 400a.

The first conductive layer 1711 and the second conductive layer 1712 may include a line that transmits power. For example, the first conductive layer 1711 may include a set of first power lines 1711a, 1711b, 1711c, and 1711d. The second conductive layer 1712 may include a set of second power lines 1712a, 1712b, 1712c, and 1712d.

In a case where there is insufficient space to dispose of a power line in the first conductive layer 1711, power lines may be disposed in the second conductive layer 1712. By disposing the power lines vertically, the utilization of a horizontal space may be increased. For example, when a current flowing through one line is 0.5 A, a current of 2 A may flow through the set of first power lines 1711a, 1711b, 1711c, and 1711d disposed on the first conductive layer 1711. When there is insufficient space to dispose of further lines in the first conductive layer 1711, the set of second power lines 1712a, 1712b, 1712c, and 1712d may be further disposed on the second conductive layer 1712 to supply a current of 4 A. Power of 2 A may be further supplied to an electronic component in an electronic device 100 through the set of second power lines 1712a, 1712b, 1712c, and 1712d. Power lines of the set of first power lines 1711a, 1711b, 1711c, and 1711d and the set of second power lines 1712a, 1712b, 1712c, and 1712d may include a copper foil pattern or a copper line.

The non-conductive layer 1721 may be disposed between the first conductive layer 1711 and the second conductive layer 1712. The non-conductive layer 1721 may operate as an insulating layer that electrically separates the first conductive layer 1711 and the second conductive layer 1712.

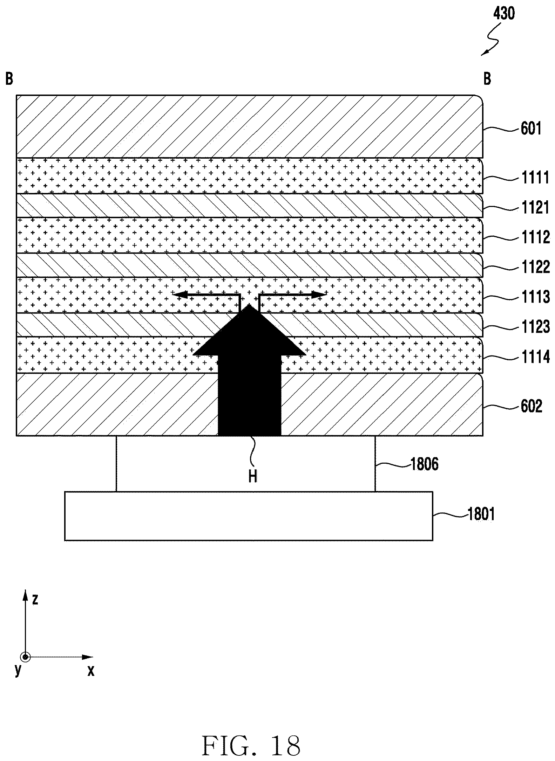

FIG. 18 is a diagram exemplarily illustrating a diffusion path of heat emitted from a heat-generating component in contact with a support plate.

FIG. 18 is a diagram illustrating a schematic diagram of a heat-generating component in contact with a cross-sectional view (e.g., a cross-sectional view cut along B-B of FIG. 5) in which an exemplary support plate 430 of a display 140 is cut.

Referring to FIG. 18, the support plate 430 may include a first support layer 601, a second support layer 602, a first conductive layer 1111, a second conductive layer 1112, a third conductive layer 1113, a fourth conductive layer 1114, a first non-conductive layer 1121, a second non-conductive layer 1122, and/or a third non-conductive layer 1123. The first support layer 601, the second support layer 602, the first conductive layer 1111, the second conductive layer 1112, the third conductive layer 1113, the fourth conductive layer 1114, the first non-conductive layer 1121, the second non-conductive layer 1122, and/or the third non-conductive layer 1123 may be the same as or similar to the configuration of FIG. 11.

An electronic device (e.g., the electronic device 100 of FIG. 1) may include an electronic component 1806 (e.g., a processor, a radio frequency integrated circuit (RFIC)) disposed on an internal PCB 1801. The electronic component 1806 may produce heat while the electronic device 100 operates. The heat generated from the electronic component 1806 may be transmitted to a support member (e.g., the first support member 311, the second support member 321, or the third support member 331 of FIG. 3) through a thermal interface material (TIM) or a heat transfer member (e.g., a heat pipe, a heat chamber). The support member (e.g., the first support member 311, the second support member 321, or the third support member 331 of FIG. 3) may transmit the received heat to the support plate 430.

Heat generated from the electronic component may be emitted, by being transmitted to the third conductive layer 1113 operating as a ground having a large area among the conductive members in the support plate 430.

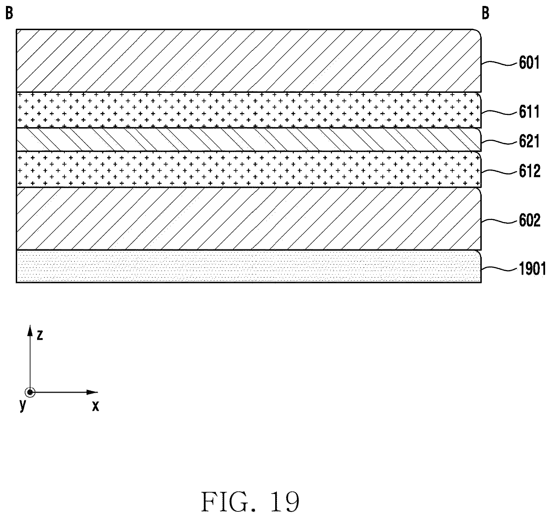

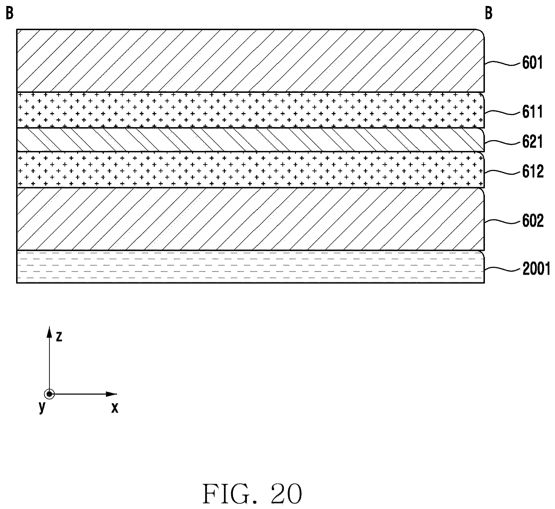

FIG. 19 is a cross-sectional view of an exemplary support plate further including a shielding layer. FIG. 20 is a cross-sectional view of an exemplary support plate further including a reinforcing layer.

FIGS. 19 and 20 are cross-sectional views (e.g., cross-sectional views cut along B-B of FIG. 5) in which an exemplary support plate 430 of a display 140 is cut.

Referring to FIGS. 19 and 20, the support plate 430 may include a first support layer 601, a second support layer 602, a first conductive layer 611, a second conductive layer 612, and/or a non-conductive layer 621. At least one of the components of the support plate 430 may be the same as at least one of the components of the support plate 430 of FIG. 6, and overlapping descriptions will be omitted below.

The support plate 430 may further include at least one of functional layers 1901 and 2001.

For example, the support plate 430 may further include a shielding layer 1901. The shielding layer 1901 may reduce transmission of noise from an outside to a conductive line included in the second conductive layer 612 or transmission of noise emitted from the second conductive layer 612 to the outside (e.g., inside the electronic device 100) of the support plate 430. The shielding layer 1901 may include conductive particles or graphite in a non-conductive layer including a polymer. For example, the conductive particles may include a metal paste (e.g., silver paste). The shielding layer 1901 may be a conductive layer formed thinly to have flexibility. The shielding layer 1901 may be formed by applying a paint including a shielding material (conductive material or graphite) onto a non-conductive layer.

The support plate 430 may further include a reinforcing layer 2001. The reinforcing layer 2001 may further include a carbon fiber reinforced plastic (CFRP). In order to reinforce a rigidity of the support layers 601 and 602 formed of GFRP instead of CFRP, a reinforcing layer formed of CFRP may be disposed on a surface of at least one layer among the support layers 601 and 602.

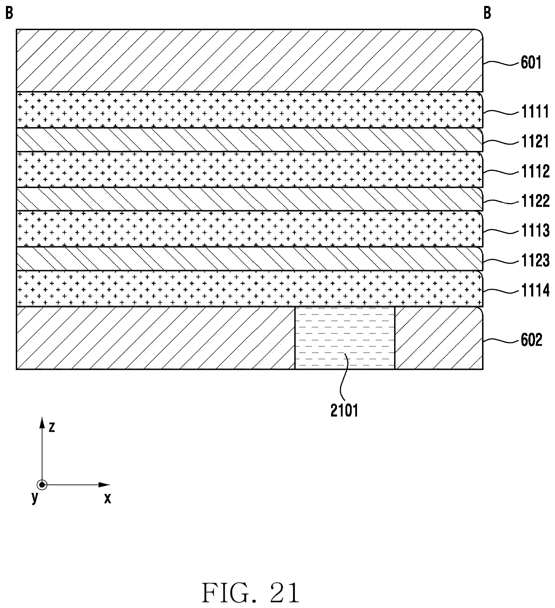

FIG. 21 is a cross-sectional view of an exemplary support plate including a connection portion for connection with a connector.

FIG. 21 is a cross-sectional view (e.g., a cross-sectional view cut along B-B of FIG. 5) in which an exemplary support plate 430 of a display 140 is cut.

Referring to FIG. 21, the support plate 430 may include a first support layer 601, a second support layer 602, a first conductive layer 1111, a second conductive layer 1112, a third conductive layer 1113, a fourth conductive layer 1114, a first non-conductive layer 1121, a second non-conductive layer 1122, and/or a third non-conductive layer 1123. The first support layer 601, the second support layer 602, the first conductive layer 1111, the second conductive layer 1112, the third conductive layer 1113, the fourth conductive layer 1114, the first non-conductive layer 1121, the second non-conductive layer 1122, and/or the third non-conductive layer 1123 may be the same as or similar to the configuration of FIG. 11.

The support plate 430 may further include a conductive pad 2101. The conductive pad 2101 may be in contact with the fourth conductive layer 1114 by penetrating the second support layer 602. The conductive pad 2101 may be exposed to an outside through the second support layer 602. The conductive pad 2101 may be bonded to a connector (e.g., the first connector 511, the second connector 512, or the third connector 513 of FIG. 5). The conductive pad 2101 may be connected to the connector 511, 512, and 513 to the fourth conductive layer 1114 by being bonded to a conductive portion of the connectors 511, 512, and 513. The fourth conductive layer 1114 may be electrically connected to a PCB (e.g., the PCB 550 of FIG. 5) in an electronic device through the connector 511, 512, and 513, and electronic components in the electronic device may transmit or receive signals to or from each other.

The conductive pad 2101 may increase accessibility to the PCB 550 by being formed on the second support layer 602 instead of the first support layer 601 facing a display panel (e.g., the display panel 401 of FIG. 4).

A bonding process of the conductive pad 2101 and the connector 511, 512, and 513 may use a bonding using an anisotropic conductive film (ACF), hot bar soldering, or induction soldering. Although the fourth conductive layer 1114 has been described as being connected to the PCB 550 by the connector 511, 512, and 513 attached to the conductive pad 2101, the fourth conductive layer 1114 may be electrically connected to the PCB 550 through a pogo pin, a conductive elastic member (conductive spring), or a contact structure in contact with the conductive pad 2101 connected to the fourth conductive layer 1114.

The connector 511, 512, and 513 for high-speed communication may adjust a width of a wiring inside the connector 511, 512, and 513 and a gap between grounds for impedance matching. In order to shield noise of the connector 511, 512, and 513, a shielding layer formed of a conductive layer may be disposed on an outside of a flexible printed circuit board (FPCB) (e.g., neck FPCB) for connecting the connector 511, 512 ,and 513.

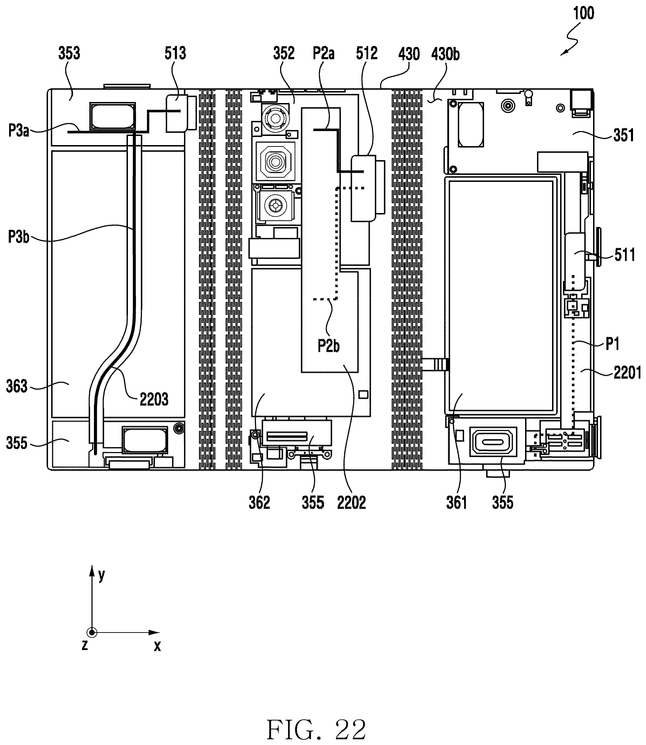

FIG. 22 is a diagram illustrating connection of an exemplary connector disposed on a support plate for connecting electronic components in an electronic device.

Referring to FIG. 22, an electronic device 100 may further include a support plate 430 and connectors 511, 512, and 513. The connectors 511, 512, and 513 may be disposed on a rear surface 430b (e.g., a surface facing the PCB or the support member) of the support plate 430. Each of the connectors 511, 512, and 513 may be disposed in a first planar part 501, a second planar part 502, or a third planar part 503. Each of the connectors 511, 512, and 513 may face a PCB 350 through a hole penetrating a corresponding support member among support members (e.g., the first support member 311, the second support member 321, and the third support member 331 of FIG. 3). The first connector 511 disposed in the first planar part 501 may be connected to a PCB disposed in the first planar part 501 among a first PCB 351, a first battery 361, or PCBs 355 through a first FPCB 2201 disposed in the first planar part 501. The second connector 512 disposed in the second planar part 502 may be connected to a PCB disposed in the second planar part 502 among a second PCB 352, a second battery 362, or the PCBs 355 through a second FPCB 2202 disposed in the second planar part 502. The third connector 513 disposed in the third planar part 503 may be connected to a PCB disposed in the third planar part 503 among a third PCB 353, a third battery 363, or the PCBs 355 through a third FPCB 2203 disposed in the third planar part 503. Although the connectors 511, 512, and 513 have been described as three, they may be plural in a multi-foldable terminal. For example, in case that one or more connectors are disposed in each of the three planar parts, the number of connectors may be three or more. The first connector 511 disposed in the first planar part 501 may be electrically connected to a wireless communication circuit (e.g., radio frequency integrated circuit (RFIC)) disposed on a PCB disposed in a first housing (e.g., the first housing 110 of FIG. 1) among the PCBs 355 through a first path P1. The second connector 512 disposed in the second planar part 502 may be electrically connected to a camera module by being connected to the second PCB 352 disposed in a second housing (e.g., the second housing 120 of FIG. 1) through a second path P2a, and may be electrically connected to a second battery through a third path P2b. The third connector 513 disposed in the third planar part 503 may be electrically connected to display driving circuitry through a fourth path P3a, and may be connected to a speaker disposed on a PCB in a third housing (e.g., the third housing 130 of FIG. 1) among the PCBs 355 through a fifth path P3b of the third FPCB 2203.

The electronic device 100 according to the above-described embodiment may electrically connect the electronic components in the electronic device 100 by using an electrical wiring disposed in the support plate 430 composing the display 140.

By using the support plate 430 implementing the electrical wiring, the electronic device 100 may secure a disposition space for disposing another electronic component and reduce thickness of the electronic device 100 by reducing the FPCB disposed inside the electronic device 100.

A foldable electronic device (e.g., the electronic device 100 of FIG. 1) according to an above-described embodiment may comprise a first housing 110 (e.g., the first housing 110 of FIG. 1) and a second housing 120 (e.g., the second housing 120 of FIG. 1) rotatably coupled to the first housing 110. The foldable electronic device 100 may comprise a first display part 141 disposed on the first housing 110 and a second display part 142 disposed on the second housing 120. The foldable electronic device 100 may further comprise a hinge structure. The hinge structure may comprise a hinge structure rotatably connecting the first housing and the second housing. The foldable electronic device 100 may further comprise a support plate (e.g., the support plate 430 of FIG. 4). The support plate may support the flexible display 140. The at least one conductive layer may connect a first printed circuit board (PCB) disposed in the first housing 110 and a second PCB disposed in the second housing 120.

According to an embodiment, the at least one conductive layer 611, 612, and 713 may include a first conductive portion 811 disposed in a first planar part 431 of the support plate 430 corresponding to the first display part 141 and extending from the conductive pattern and a second conductive portion 812 disposed in a second planar part 432 of the support plate 430 corresponding to the second display part 142 and extending from the conductive pattern.

According to an embodiment, the support plate 430 may further include a second support layer 602 disposed on the at least one conductive layer.

According to an embodiment, the support plate 430 may include a first connector connecting the first PCB and the first conductive portion 811 and a second connector connecting the second PCB and the second conductive portion 812.

According to an embodiment, the at least one conductive layer 611, 612, and 713 may be configured to electromagnetically interact with an external object by including a first conductive layer 911 including a set 1010 of first conductive patterns (structures) extending in a direction parallel to a folding axis and a second conductive layer 912 disposed under the first conductive layer and including a set 1020 of second conductive patterns (structures) extending in a direction perpendicular to the folding axis.

According to an embodiment, the at least one conductive layer 611, 612, and 713 may include a first conductive layer 611 connected to a conductive portion in the foldable electronic device 100 and act as a ground and a second conductive layer 612 connected to the first PCB and the second PCB and act as a transmission line.

According to an embodiment, the support plate 430 may further include a plurality of slits disposed on the hinge structure.

According to an embodiment, the conductive pattern in the first conductive layer 611 corresponding to at least some of the plurality of slits may include a plurality of openings.

According to an embodiment, the foldable electronic device may further comprise a non-conductive layer interposed between the at least one conductive layer 611, 612, and 713.

According to an embodiment, the non-conductive layer may include a same material as the support plate 430.

According to an embodiment, the support plate 430 may include a glass fiber reinforced plastic (GFRP).

According to an embodiment, the conductive pattern may include a first conductive line extending between the slits and a second conductive line extending between the slits and spaced apart from the first conductive line. The conductive pattern may be configured to transmit a signal from the first PCB to the second PCB.

The conductive pattern may include a first conductive line and a second conductive line extending meanderingly between the slits and spaced apart from each other.

The support plate 430 may include a first support layer disposed between a surface of the least one conductive layer 611, 612, and 713 and the flexible display 140, and a second support layer disposed on another surface of the at least one conductive layer 611, 612, and 713.

According to an embodiment, the support plate 430 may further include a third support layer in contact with the second support layer.

According to an embodiment, the first support layer and the second support layer may include GFRP and the third support layer may include carbon fiber reinforced plastic (CFRP) to reinforce a rigidity of the support plate 430.

According to an embodiment, a relative permittivity of the support plate 430 may be 1 to 5.

According to an embodiment, the at least one conductive layer 611, 612, and 713 may include a first conductive layer and a second conductive layer connected to the first PCB and the second PCB.

According to an embodiment, the first conductive layer may be electrically connected to the second conductive layer through a conductive via disposed in a non-conductive layer between the first conductive layer and the second conductive layer.

According to an embodiment, the support plate 430 may be configured to reduce distortion of a signal transmitted through the at least one conductive layer 611, 612, and 713 by further including a shielding layer including graphite or metal pastes on a surface facing the first PCB and the second PCB.

According to an embodiment, an electronic device 100 may further comprise a third housing rotatably coupled to the second housing. The flexible display 140 may further include the third display part 143 configured to be bent when the foldable electronic device 100 is folded relative to a folding axis between the first housing and the second housing, a fourth display part disposed on the third housing, and a fifth display part between the second display part 142 and the fourth display part configured to be bent when the foldable electronic device 100 is folded relative to a folding axis between the second housing 120 and the third housing.

The support plate 430 may further include another deformable part arranged in the fifth display part and having a plurality of slits.

The at least one conductive layer 611, 612, and 713 may have another conductive pattern corresponding to at least some of the plurality of slits in the another deformable part and may connect the second PCB and a third PCB disposed in the third housing.

According to an embodiment, the at least one conductive layer 611, 612, and 713 may include a first conductive portion 811 disposed in a first planar part 431 of the support plate 430 corresponding to the first display part 141 and extending from the conductive pattern, a second conductive portion 812 disposed in a second planar part 432 of the support plate 430 corresponding to the second display part 142 and extending from the conductive pattern to the another conductive pattern, and a third conductive portion 813 disposed in a third planar part of the support plate 430 corresponding to the fourth display part and extending from the another conductive pattern.

The support plate 430 may include a first connector connecting the first PCB and the first conductive portion 811, a second connector connecting the second PCB and the second conductive portion 812, and a third connector connecting the third PCB and the third conductive portion 813.

A foldable electronic device 100 may comprise a first housing 110, a second housing 120 rotatably coupled to the first housing 110, a third housing 130 rotatably coupled to the second housing 120, a flexible display 140 including a first display part 141 disposed on the first housing 110, a second display part 142 disposed on the second housing 120, a third display part 143 between the first display part 141 and the second display part 142 configured to be bent when the first housing 110 and the second housing 120 are folded relative to a first folding axis, a fourth display part disposed on the third housing, and a fifth display part between the second display part 142 and the fourth display part configured to be bent when the second housing 120 and the third housing are folded relative to a second folding axis, and a support plate 430 including a first deformable part arranged in the third display part 143 and having a plurality of slits and a second deformable part arranged in the fifth display part and having a plurality of slits, including a non-conductive material and supporting the flexible display 140.

The support plate 430 may include a first support layer supporting the flexible display 140 and disposed under the flexible display 140, at least one conductive layer 611, 612, and 713 disposed under the first support layer and including a first conductive pattern corresponding to at least some of the plurality of slits in the first deformable part and a second conductive pattern corresponding to at least some of the plurality of slits in the second deformable part, and a second support layer disposed under the at least one conductive layer 611, 612, and 713.

According to an embodiment, the support plate may be connected to a first PCB in the first housing 110, a second PCB in the second housing 120, and a third PCB in the third housing.

According to an embodiment, the at least one conductive layer 611, 612, and 713 may include a first conductive portion 811 disposed in a first planar part 431 of the support plate 430 corresponding to the first display part 141 and extending from the first conductive pattern, a second conductive portion 812 disposed in a second planar part 432 of the support plate 430 corresponding to the second display part 142 and extending from the first conductive pattern to the second conductive pattern, and a third conductive portion 813 disposed in a third planar part of the support plate 430 corresponding to the fourth display part and extending from the second conductive pattern.

The support plate 430 may include a first connector connecting the first PCB and the first conductive portion 811, a second connector connecting the second PCB and the second conductive portion 812, and a third connector connecting the third PCB and the third conductive portion 813.

The support plate may further include non-conductive layer interposed between the at least one conductive layer 611, 612, and 713

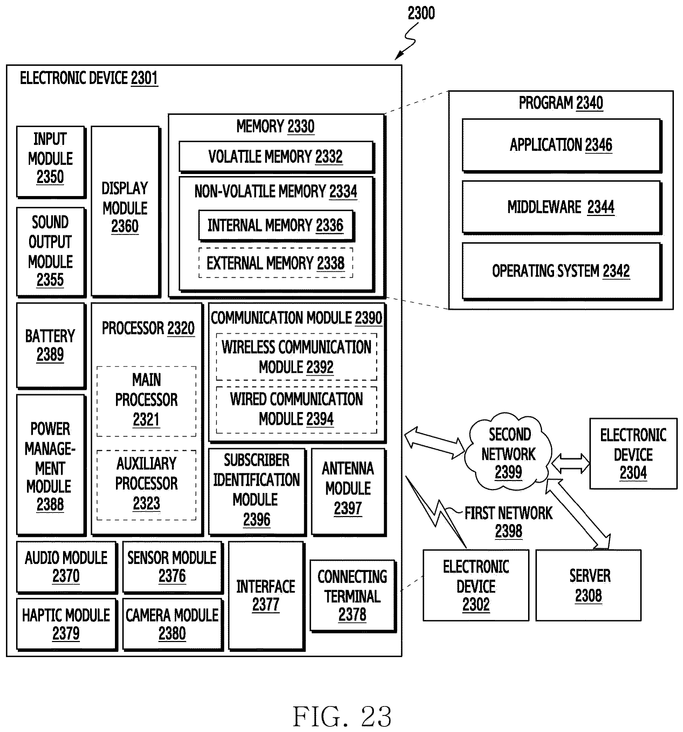

FIG. 23 is a block diagram illustrating an electronic device 2301 in a network environment 2300 according to various embodiments. Referring to FIG. 23, the electronic device 2301 in the network environment 2300 may communicate with an electronic device 2302 via a first network 2398 (e.g., a short-range wireless communication network), or at least one of an electronic device 2304 or a server 2308 via a second network 2399 (e.g., a long-range wireless communication network). According to an embodiment, the electronic device 2301 may communicate with the electronic device 2304 via the server 2308. According to an embodiment, the electronic device 2301 may include a processor 2320, memory 2330, an input module 2350, a sound output module 2355, a display module 2360, an audio module 2370, a sensor module 2376, an interface 2377, a connecting terminal 2378, a haptic module 2379, a camera module 2380, a power management module 2388, a battery 2389, a communication module 2390, a subscriber identification module(SIM) 2396, or an antenna module 2397. In some embodiments, at least one of the components (e.g., the connecting terminal 2378) may be omitted from the electronic device 2301, or one or more other components may be added in the electronic device 2301. In some embodiments, some of the components (e.g., the sensor module 2376, the camera module 2380, or the antenna module 2397) may be implemented as a single component (e.g., the display module 2360).

The processor 2320 may execute, for example, software (e.g., a program 2340) to control at least one other component (e.g., a hardware or software component) of the electronic device 2301 coupled with the processor 2320, and may perform various data processing or computation. According to an embodiment, as at least part of the data processing or computation, the processor 2320 may store a command or data received from another component (e.g., the sensor module 2376 or the communication module 2390) in volatile memory 2332, process the command or the data stored in the volatile memory 2332, and store resulting data in non-volatile memory 2334. According to an embodiment, the processor 2320 may include a main processor 2321 (e.g., a central processing unit (CPU) or an application processor (AP)), or an auxiliary processor 2323 (e.g., a graphics processing unit (GPU), a neural processing unit (NPU), an image signal processor (ISP), a sensor hub processor, or a communication processor (CP)) that is operable independently from, or in conjunction with, the main processor 2321. For example, when the electronic device 2301 includes the main processor 2321 and the auxiliary processor 2323, the auxiliary processor 2323 may be adapted to consume less power than the main processor 2321, or to be specific to a specified function. The auxiliary processor 2323 may be implemented as separate from, or as part of the main processor 2321.

The auxiliary processor 2323 may control at least some of functions or states related to at least one component (e.g., the display module 2360, the sensor module 2376, or the communication module 2390) among the components of the electronic device 2301, instead of the main processor 2321 while the main processor 2321 is in an inactive (e.g., sleep) state, or together with the main processor 2321 while the main processor 2321 is in an active state (e.g., executing an application). According to an embodiment, the auxiliary processor 2323 (e.g., an image signal processor or a communication processor) may be implemented as part of another component (e.g., the camera module 2380 or the communication module 2390) functionally related to the auxiliary processor 2323. According to an embodiment, the auxiliary processor 2323 (e.g., the neural processing unit) may include a hardware structure specified for artificial intelligence model processing. An artificial intelligence model may be generated by machine learning. Such learning may be performed, e.g., by the electronic device 2301 where the artificial intelligence is performed or via a separate server (e.g., the server 2308). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 2330 may store various data used by at least one component (e.g., the processor 2320 or the sensor module 2376) of the electronic device 2301. The various data may include, for example, software (e.g., the program 2340) and input data or output data for a command related thereto. The memory 2330 may include the volatile memory 2332 or the non-volatile memory 2334.

The program 2340 may be stored in the memory 2330 as software, and may include, for example, an operating system (OS) 2342, middleware 2344, or an application 2346.

The input module 2350 may receive a command or data to be used by another component (e.g., the processor 2320) of the electronic device 2301, from the outside (e.g., a user) of the electronic device 2301. The input module 2350 may include, for example, a microphone, a mouse, a keyboard, a key (e.g., a button), or a digital pen (e.g., a stylus pen).

The sound output module 2355 may output sound signals to the outside of the electronic device 2301. The sound output module 2355 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 2360 may visually provide information to the outside (e.g., a user) of the electronic device 2301. The display module 2360 may include, for example, a display, a hologram device, or a projector and control circuitry to control a corresponding one of the display, hologram device, and projector. According to an embodiment, the display module 2360 may include a touch sensor adapted to detect a touch, or a pressure sensor adapted to measure the intensity of force incurred by the touch.

The audio module 2370 may convert a sound into an electrical signal and vice versa. According to an embodiment, the audio module 2370 may obtain the sound via the input module 2350, or output the sound via the sound output module 2355 or a headphone of an external electronic device (e.g., an electronic device 2302) directly (e.g., wiredly) or wirelessly coupled with the electronic device 2301.

The sensor module 2376 may detect an operational state (e.g., power or temperature) of the electronic device 2301 or an environmental state (e.g., a state of a user) external to the electronic device 2301, and then generate an electrical signal or data value corresponding to the detected state. According to an embodiment, the sensor module 2376 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 2377 may support one or more specified protocols to be used for the electronic device 2301 to be coupled with the external electronic device (e.g., the electronic device 2302) directly (e.g., wiredly) or wirelessly. According to an embodiment, the interface 2377 may include, for example, a high definition multimedia interface (HDMI), a universal serial bus (USB) interface, a secure digital (SD) card interface, or an audio interface.

A connecting terminal 2378 may include a connector via which the electronic device 2301 may be physically connected with the external electronic device (e.g., the electronic device 2302). According to an embodiment, the connecting terminal 2378 may include, for example, an HDMI connector, a USB connector, a SD card connector, or an audio connector (e.g., a headphone connector).

The haptic module 2379 may convert an electrical signal into a mechanical stimulus (e.g., a vibration or a movement) or electrical stimulus which may be recognized by a user via his tactile sensation or kinesthetic sensation. According to an embodiment, the haptic module 2379 may include, for example, a motor, a piezoelectric element, or an electric stimulator.

The camera module 2380 may capture a still image or moving images. According to an embodiment, the camera module 2380 may include one or more lenses, image sensors, image signal processors, or flashes.

The power management module 2388 may manage power supplied to the electronic device 2301. According to an embodiment, the power management module 2388 may be implemented as at least part of, for example, a power management integrated circuit (PMIC).

The battery 2389 may supply power to at least one component of the electronic device 2301. According to an embodiment, the battery 2389 may include, for example, a primary cell which is not rechargeable, a secondary cell which is rechargeable, or a fuel cell.

The communication module 2390 may support establishing a direct (e.g., wired) communication channel or a wireless communication channel between the electronic device 2301 and the external electronic device (e.g., the electronic device 2302, the electronic device 2304, or the server 2308) and performing communication via the established communication channel. The communication module 2390 may include one or more communication processors that are operable independently from the processor 2320 (e.g., the application processor (AP)) and supports a direct (e.g., wired) communication or a wireless communication. According to an embodiment, the communication module 2390 may include a wireless communication module 2392 (e.g., a cellular communication module, a short-range wireless communication module, or a global navigation satellite system (GNSS) communication module) or a wired communication module 2394 (e.g., a local area network (LAN) communication module or a power line communication (PLC) module). A corresponding one of these communication modules may communicate with the external electronic device via the first network 2398 (e.g., a short-range communication network, such as Bluetooth^{™}, wireless-fidelity (Wi-Fi) direct, or infrared data association (IrDA)) or the second network 2399 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 2392 may identify and authenticate the electronic device 2301 in a communication network, such as the first network 2398 or the second network 2399, using subscriber information (e.g., international mobile subscriber identity (IMSI)) stored in the subscriber identification module 2396.

The wireless communication module 2392 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 2392 may support a high-frequency band (e.g., the mmWave band) to achieve, e.g., a high data transmission rate. The wireless communication module 2392 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 2392 may support various requirements specified in the electronic device 2301, an external electronic device (e.g., the electronic device 2304), or a network system (e.g., the second network 2399). According to an embodiment, the wireless communication module 2392 may support a peak data rate (e.g., 20Gbps or more) for implementing eMBB, loss coverage (e.g., 2364dB or less) for implementing mMTC, or U-plane latency (e.g., 0.5ms or less for each of downlink (DL) and uplink (UL), or a round trip of 23ms or less) for implementing URLLC.

The antenna module 2397 may transmit or receive a signal or power to or from the outside (e.g., the external electronic device) of the electronic device 2301. According to an embodiment, the antenna module 2397 may include an antenna including a radiating element composed of a conductive material or a conductive pattern formed in or on a substrate (e.g., a printed circuit board (PCB)). According to an embodiment, the antenna module 2397 may include a plurality of antennas (e.g., array antennas). In such a case, at least one antenna appropriate for a communication scheme used in the communication network, such as the first network 2398 or the second network 2399, may be selected, for example, by the communication module 2390 (e.g., the wireless communication module 2392) from the plurality of antennas. The signal or the power may then be transmitted or received between the communication module 2390 and the external electronic device via the selected at least one antenna. According to an embodiment, another component (e.g., a radio frequency integrated circuit (RFIC)) other than the radiating element may be additionally formed as part of the antenna module 2397.

According to various embodiments, the antenna module 2397 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 2301 and the external electronic device 2304 via the server 2308 coupled with the second network 2399. Each of the electronic devices 2302 or 2304 may be a device of a same type as, or a different type, from the electronic device 2301. According to an embodiment, all or some of operations to be executed at the electronic device 2301 may be executed at one or more of the external electronic devices 2302, 2304, or 2308. For example, if the electronic device 2301 should perform a function or a service automatically, or in response to a request from a user or another device, the electronic device 2301, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 2301. The electronic device 2301 may provide the outcome, with or without further processing of the outcome, as at least part of a reply to the request. To that end, a cloud computing, distributed computing, mobile edge computing (MEC), or client-server computing technology may be used, for example. The electronic device 2301 may provide ultra low-latency services using, e.g., distributed computing or mobile edge computing. In another embodiment, the external electronic device 2304 may include an internet-of-things (IoT) device. The server 2308 may be an intelligent server using machine learning and/or a neural network. According to an embodiment, the external electronic device 2304 or the server 2308 may be included in the second network 2399. The electronic device 2301 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 2340) including one or more instructions that are stored in a storage medium (e.g., internal memory 2336 or external memory 2338) that is readable by a machine (e.g., the electronic device 2301). For example, a processor (e.g., the processor 2320) of the machine (e.g., the electronic device 2301) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Another aspect of the present disclosure related to a foldable electronic device comprising: a first housing; a second housing rotatably coupled to the first housing; a third housing rotatably coupled to the second housing; a flexible display including: a first display part disposed on the first housing; a second display part disposed on the second housing; and a third display part between the first display part and the second display part, the third display part configured to be bent when the first housing and the second housing are folded relative to a first folding axis, a fourth display part disposed on the third housing; and a fifth display part between the second display part and the fourth display part, the fifth display part configured to be bent when the second housing and the third housing are folded relative to a second folding axis; and a support plate including: a first deformable part arranged in the third display part and having a plurality of slits; and a second deformable part arranged in the fifth display part and having a plurality of slits, the support plate supporting the flexible display; wherein the support plate further includes: a first support layer formed from a non-conductive material and disposed under the flexible display; at least one conductive layer disposed under the first support layer, the at least one conductive layer including a first conductive pattern corresponding to at least some of the plurality of slits in the first deformable part and a second conductive pattern corresponding to at least some of the plurality of slits in the second deformable part; and a second support layer disposed under the at least one conductive layer and wherein the at least one conductive layer electrically connects a first printed circuit board, PCB, disposed in the first housing, a second PCB disposed in the second housing, and a third PCB disposed in the third housing.

According to an embodiment of said aspect of the present disclosure, the at least one conductive layer includes a first conductive portion disposed in a first planar part of the support plate corresponding to the first display part and extending from the first conductive pattern, a second conductive portion disposed in a second planar part of the support plate corresponding to the second display part and extending from the first conductive pattern to the second conductive pattern, and a third conductive portion disposed in a third planar part of the support plate corresponding to the fourth display part and extending from the second conductive pattern, wherein the support plate includes a first connector connecting the first PCB and the first conductive portion and a second connector connecting the second PCB and the second conductive portion and the third connector connecting a third PCB and the third conductive portion.

According to an embodiment, the foldable electronic device of said aspect of the present disclosure comprises a non-conductive layer interposed between the at least one conductive layer.

## Claims

1. A foldable electronic device (100) comprising:
a foldable housing including:
a first housing (110),
a second housing (120), and
a hinge structure configured to rotatably connect the first housing (110) and the second housing (120); and
a flexible display (140) including:
a display panel (401), and
a support plate (430) disposed under the display panel (401) to support the display panel (401); and
at least one conductive layer (611; 612; 713) embedded within the support plate (430),
wherein the at least one conductive layer (611; 612; 713) is electrically connected to a first printed circuit board, PCB, disposed in the first housing (110) and a second PCB disposed in the second housing (120).

2. The foldable electronic device (100) of claim 1, wherein the at least one conductive layer (611; 612; 713) includes:
a first conductive portion (811) embedded within a first planar part (431) of the support plate (430) corresponding to a first display part (141) of the flexible display (140) disposed on the first housing (110),
a second conductive portion (812) embedded within a second planar part (432) of the support plate (430) corresponding to a second display part (142) of the flexible display (140) disposed on the second housing (110), and
a conductive pattern embedded within a bendable part (433) of the support plate (430) extending from the first planar part (431) to the second planar part (432), wherein the bendable part (433) is bent, when the foldable electronic device (100) is in a folded state, and
wherein the support plate (430) includes:
a first connector (511) connecting the first PCB and the first conductive portion (811), and
a second connector (512) connecting the second PCB and the second conductive portion (812).

3. The foldable electronic device (100) of claim 1 or 2, wherein the support plate (430) includes a first support layer (601) and a second support layer (602), the first and second support layers (601, 602) comprising a glass fiber reinforced plastic, GFRP, and
wherein the at least one conductive layer (611; 612; 713) is disposed between the first and second support layers (601, 602).

4. The foldable electronic device (100) of any one of claims 1 to 3, wherein the at least one conductive layer (611; 612; 713) is configured to electromagnetically interact with an external object by including a first conductive layer (911) including a set of first conductive structures (1010) extending in a direction parallel to a folding axis and a second conductive layer (912) disposed under the first conductive layer (911) and including a set of second conductive structures (1020) extending in a direction perpendicular to the folding axis.

5. The foldable electronic device (100) of any one of claims 1 to 4, wherein the at least one conductive layer (611; 612; 713) includes:
a first conductive layer (611) connected to a conductive portion in the foldable electronic device (100) and acts as a ground, and
a second conductive layer (612) connected to the first PCB and the second PCB and act as a transmission line,
wherein the support plate (430) includes a plurality of slits, the plurality of slits disposed to overlap the hinge structure, and
wherein the at least one conductive layer (611; 612; 713) includes a conductive pattern in the first conductive layer (611) corresponding to at least some of the plurality of slits including a plurality of openings.

6. The foldable electronic device (100) of any one of claims 1 to 5, wherein the at least one conductive layer (611; 612; 713) includes at least two conductive layers, and
wherein the support plate (430) includes a non-conductive layer (621;722) interposed between the at least two conductive layers.

7. The foldable electronic device (100) of claim 6, wherein the non-conductive layer includes a same material as the support plate (430).

8. The foldable electronic device (100) of any one of claims 1 to 7, wherein the support plate (430) comprises a GFRP.

9. The foldable electronic device (100) of any one of claims 1 to 8, wherein the at least one conductive layer (611; 612; 713) includes a conductive pattern disposed to overlap the hinge structure,
wherein the conductive pattern includes:
a first conductive line extending between a plurality of slits disposed in a bending area of the support plate, and
a second conductive line spaced apart from the first conductive line and extending between the plurality of slits, and
wherein the conductive pattern is configured to transmit a signal from the first PCB to the second PCB.

10. The foldable electronic device (100) of any one of claims 1 to 9, wherein the at least one conductive layer (611; 612; 713) includes a first conductive line and a second conductive line,
wherein the conductive pattern extends meanderingly between a plurality of slits disposed in a bending area of the supporting plate and are spaced apart from each other.

11. The foldable electronic device (100) of any one of claims 1 to 10, wherein the support plate (430) includes:
a first support layer disposed between a surface of the least one conductive layer and the display panel (401), and
a second support layer disposed on another surface of the at least one conductive layer (611; 612; 713).

12. The foldable electronic device (100) of any one of claims 1 to 11, wherein the at least one conductive layer (611; 612; 713) includes a first conductive layer and a second conductive layer, the first and second conductive layers connected to the first PCB and the second PCB, and
wherein the first conductive layer is electrically connected to the second conductive layer through a conductive via disposed in a non-conductive layer between the first conductive layer and the second conductive layer.

13. The foldable electronic device (100) of any one of claims 1 to 12, wherein the support plate (430) is configured to reduce distortion of the signal transmitted through the at least one conductive layer (611; 612; 713) by further including a shielding layer including graphite or metal pastes on a surface facing the first PCB and the second PCB.

14. The foldable electronic device (100) of any one of claims 1 to 13, further comprising a third housing rotatably coupled to the second housing (120),
wherein the at least one conductive layer (611; 612; 713) is electrically connected to a third PCB disposed in the third housing.

15. The foldable electronic device (100) of claim 14, wherein the at least one conductive layer (611; 612; 713) includes:
a first conductive portion (811) embedded within a first planar part (431) of the support plate (430) corresponding to a first display part (141) of the flexible display (140) disposed on the first housing (110),
a second conductive portion (812) embedded within a second planar part (432) of the support plate 430 corresponding to a second display part (142) of the flexible display (140) disposed on the second housing (120), and
a third conductive portion (813) disposed in a third planar part of the support plate (430) corresponding to a third display part of the flexible display (140) disposed on the third housing (130), and
wherein the support plate (430) includes:
a first connector (511) connecting the first PCB and the first conductive portion (811),
a second connector (512) connecting the second PCB and the second conductive portion (812), and
a third connector (513) connecting the third PCB and the third conductive portion(813).

## Patentansprüche

1. Faltbare elektronische Vorrichtung (100), umfassend:
ein faltbares Gehäuse, umfassend:
ein erstes Gehäuse (110),
ein zweites Gehäuse (120), und
eine Scharnierstruktur, die konfiguriert ist, um das erste Gehäuse (110) und das zweite Gehäuse (120) drehbar miteinander zu verbinden; und
eine flexible Anzeige (140), umfassend:
eine Anzeigetafel (401), und
eine unter der Anzeigetafel (401) angeordnete Trägerplatte (430) zum Stützen der Anzeigetafel (401); und
mindestens eine leitfähige Schicht (611; 612; 713), die in die Trägerplatte (430) eingebettet ist,
wobei die mindestens eine leitfähige Schicht (611; 612; 713) elektrisch mit einer ersten Leiterplatte, PCB, die im ersten Gehäuse (110) angeordnet ist, und einer zweiten Leiterplatte, PCB, die im zweiten Gehäuse (120) angeordnet ist, verbunden ist.

2. Faltbare elektronische Vorrichtung (100) nach Anspruch 1, wobei die mindestens eine leitfähige Schicht (611; 612; 713) umfasst:
einen ersten leitfähigen Abschnitt (811), der in einen ersten ebenen Teil (431) der Trägerplatte (430) eingebettet ist, der einem ersten Anzeigeteil (141) der flexiblen Anzeige (140) entspricht, die auf dem ersten Gehäuse (110) angeordnet ist,
einen zweiten leitfähigen Abschnitt (812), der in einen zweiten ebenen Teil (432) der Trägerplatte (430) eingebettet ist und einem zweiten Anzeigeteil (142) der flexiblen Anzeige (140) entspricht, die am zweiten Gehäuse (110) angeordnet ist, und
ein leitfähiges Muster, das in einen biegbaren Abschnitt (433) der Trägerplatte eingebettet ist (430), der sich vom ersten ebenen Abschnitt (431) zum zweiten ebenen Abschnitt (432) erstreckt, wobei der biegbare Abschnitt (433) gebogen ist, wenn sich die faltbare elektronische Vorrichtung (100) in einem gefalteten Zustand befindet, und wobei die Trägerplatte (430) umfasst:
einen ersten Verbinder (511), der die erste PCB und den ersten leitfähigen Abschnitt (811) miteinander verbindet, und
einen zweiten Verbinder (512), der die zweite PCB und den zweiten leitfähigen Abschnitt (812) miteinander verbindet.

3. Faltbare elektronische Vorrichtung (100) nach Anspruch 1 oder 2, wobei die Trägerplatte (430) eine erste Trägerschicht (601) und eine zweite Trägerschicht (602) umfasst, wobei die erste und die zweite Trägerschicht (601, 602) glasfaserverstärkten Kunststoff, GFK, umfassen und
wobei die mindestens eine leitfähige Schicht (611; 612; 713) zwischen der ersten und der zweiten Trägerschicht (601, 602) angeordnet ist.

4. Faltbare elektronische Vorrichtung (100) nach einem der Ansprüche 1 bis 3, wobei die mindestens eine leitfähige Schicht (611; 612; 713) konfiguriert ist, um elektromagnetisch mit einem externen Objekt in Wechselwirkung zu treten, indem sie eine erste leitfähige Schicht (911), die einen Satz erster leitender Strukturen (1010) enthält, die sich in einer Richtung parallel zu einer Faltachse erstrecken, und eine zweite leitfähige Schicht (912) umfasst, die unter der ersten leitfähigen Schicht (911) angeordnet ist und einen Satz von zweiten leitenden Strukturen (1020) umfasst, die sich in einer Richtung senkrecht zur Faltachse erstrecken.

5. Faltbare elektronische Vorrichtung (100) nach einem der Ansprüche 1 bis 4, wobei die mindestens eine leitfähige Schicht (611; 612; 713) umfasst:
eine erste leitfähige Schicht (611), die mit einem leitfähigen Abschnitt in der faltbaren elektronischen Vorrichtung (100) verbunden ist und als Masse fungiert, und
eine zweite leitfähige Schicht (612), die mit der ersten PCB und der zweiten PCB verbunden ist und als Übertragungsleitung fungiert,
wobei die Trägerplatte (430) eine Vielzahl von Schlitzen umfasst, wobei die Vielzahl von Schlitzen so angeordnet sind, dass sie die Scharnierstruktur überlappen, und
wobei die mindestens eine leitfähige Schicht (611; 612; 713) ein leitfähiges Muster in der ersten leitfähigen Schicht (611) umfasst, das mindestens einigen der Vielzahl von Schlitzen entspricht, die eine Vielzahl von Öffnungen umfassen.

6. Faltbare elektronische Vorrichtung (100) nach einem der Ansprüche 1 bis 5, wobei die mindestens eine leitfähige Schicht (611; 612; 713) mindestens zwei leitfähige Schichten umfasst, und
wobei die Trägerplatte (430) eine nichtleitende Schicht (621; 722) umfasst, die zwischen den mindestens zwei leitenden Schichten angeordnet ist.

7. Faltbare elektronische Vorrichtung (100) nach Anspruch 6, wobei die nichtleitende Schicht das gleiche Material umfasst wie die Trägerplatte (430).

8. Faltbare elektronische Vorrichtung (100) nach einem der Ansprüche 1 bis 7, wobei die Trägerplatte (430) einen GFRP umfasst.

9. Faltbare elektronische Vorrichtung (100) nach einem der Ansprüche 1 bis 8, wobei die mindestens eine leitfähige Schicht (611; 612; 713) ein leitfähiges Muster umfasst, das so angeordnet ist, dass es die Scharnierstruktur überlappt,
wobei das leitfähige Muster umfasst:
eine erste leitfähige Leitung, die sich zwischen einer Vielzahl von Schlitzen erstreckt, die in einem Biegebereich der Trägerplatte angeordnet sind, und
eine zweite leitfähige Leitung, die von der ersten leitfähigen Leitung beabstandet ist und sich zwischen der Vielzahl von Schlitzen erstreckt, und
wobei das leitfähige Muster konfiguriert ist, um ein Signal von der ersten PCB zur zweiten PCB zu übertragen.

10. Faltbare elektronische Vorrichtung (100) nach einem der Ansprüche 1 bis 9, wobei die mindestens eine leitfähige Schicht (611; 612; 713) eine erste leitfähige Leitung und eine zweite leitfähige Leitung umfasst,
wobei sich das leitfähige Muster mäanderförmig zwischen einer Vielzahl von Schlitzen erstreckt, die in einem Biegebereich der Trägerplatte angeordnet und voneinander beabstandet sind.

11. Faltbare elektronische Vorrichtung (100) nach einem der Ansprüche 1 bis 10, wobei die Trägerplatte (430) umfasst:
eine erste Trägerschicht, die zwischen einer Fläche der mindestens einen leitfähigen Schicht und der Anzeigetafel (401) angeordnet ist, und
eine zweite Trägerschicht, die auf einer anderen Fläche der mindestens einen leitfähigen Schicht (611; 612; 713) angeordnet ist.

12. Faltbare elektronische Vorrichtung (100) nach einem der Ansprüche 1 bis 11, wobei die mindestens eine leitfähige Schicht (611; 612; 713) eine erste leitfähige Schicht und eine zweite leitfähige Schicht umfasst, wobei die erste und die zweite leitfähige Schicht mit der ersten PCB und der zweiten PCB verbunden sind, und
wobei die erste leitfähige Schicht über eine leitfähige Durchkontaktierung, die in einer nichtleitenden Schicht zwischen der ersten und der zweiten leitfähigen Schicht angeordnet ist, elektrisch mit der zweiten leitfähigen Schicht verbunden ist.

13. Faltbare elektronische Vorrichtung (100) nach einem der Ansprüche 1 bis 12, wobei die Trägerplatte (430) konfiguriert ist, um eine Verzerrung des übertragenen Signals durch die mindestens eine leitfähige Schicht (611; 612; 713) zu verringern, indem sie ferner eine Abschirmschicht umfasst, die Graphit- oder Metallpasten auf einer Fläche umfasst, die der ersten PCB und der zweiten PCB zugewandt ist.

14. Faltbare elektronische Vorrichtung (100) nach einem der Ansprüche 1 bis 13, die ferner ein drittes Gehäuse umfasst, das drehbar mit dem zweiten Gehäuse (120) gekoppelt ist,
wobei die mindestens eine leitfähige Schicht (611; 612; 713) elektrisch mit einer dritten PCB verbunden ist, die in dem dritten Gehäuse angeordnet ist.

15. Faltbare elektronische Vorrichtung (100) nach Anspruch 14, wobei die mindestens eine leitfähige Schicht (611; 612; 713) umfasst:
einen ersten leitfähigen Abschnitt (811), der in einen ersten ebenen Teil (431) der Trägerplatte (430) eingebettet ist, der einem ersten Anzeigeteil (141) der flexiblen Anzeige (140) entspricht, die auf dem ersten Gehäuse (110) angeordnet ist,
einen zweiten leitfähigen Abschnitt (812), der in einen zweiten ebenen Teil (432) der Trägerplatte 430 eingebettet ist und einem zweiten Anzeigeteil (142) der flexiblen Anzeige (140) entspricht, die am zweiten Gehäuse (120) angeordnet ist, und
einen dritten leitfähigen Abschnitt (813), der in einem dritten ebenen Teil der Trägerplatte (430) angeordnet ist und einem dritten Anzeigeteil der flexiblen Anzeige (140) entspricht, die auf dem dritten Gehäuse (130) angeordnet ist, und
wobei die Trägerplatte (430) umfasst:
einen ersten Verbinder (511), der die erste PCB und den ersten leitfähigen Abschnitt (811) miteinander verbindet,
einen zweiten Verbinder (512), der die zweite PCB und den zweiten leitfähigen Abschnitt (812) miteinander verbindet, und
einen dritten Verbinder (513), der die dritte PCB und den dritten leitfähigen Abschnitt (813) miteinander verbindet.

## Revendications

1. Dispositif électronique pliable (100), comprenant :
un boîtier pliable comprenant :
un premier boîtier (110),
un deuxième boîtier (120), et
une structure de charnière configurée pour relier de manière rotative le premier boîtier (110) et le deuxième boîtier (120) ; et
un affichage flexible (140) comprenant :
un panneau d'affichage (401), et
une plaque de support (430) disposée sous le panneau d'affichage (401) afin de supporter le panneau d'affichage (401) ; et
au moins une couche conductrice (611 ; 612 ; 713) intégrée dans la plaque de support (430),
dans lequel l'au moins une couche conductrice (611 ; 612 ; 713) est reliée électriquement à une première carte de circuit imprimé, PCB, disposée dans le premier boîtier (110) et à une deuxième carte de circuit imprimé, PCB, disposée dans le deuxième boîtier (120).

2. Dispositif électronique pliable (100) selon la revendication 1, dans lequel l'au moins une couche conductrice (611 ; 612 ; 713) comprend :
une première partie conductrice (811) intégrée dans une première partie plane (431) de la plaque de support (430) correspondant à une première partie d'affichage (141) de l'affichage flexible (140) disposé sur le premier boîtier (110),
une deuxième partie conductrice (812) intégrée dans une deuxième partie plane (432) de la plaque de support (430), correspondant à une deuxième partie d'affichage (142) de l'affichage flexible (140) disposé sur le deuxième boîtier (110), et
un motif conducteur intégré dans une partie pliable (433) de la plaque de support (430) s'étendant de la première partie plane (431) à la deuxième partie plane (432), dans lequel la partie pliable (433) est courbée lorsque le dispositif électronique pliable (100) est à l'état plié, et
dans lequel la plaque de support (430) comprend :
un premier connecteur (511) reliant la première PCB et la première partie conductrice (811), et
un deuxième connecteur (512) reliant la deuxième PCB et la deuxième partie conductrice (812).

3. Dispositif électronique pliable (100) selon la revendication 1 ou 2, dans lequel la plaque de support (430) comprend une première couche de support (601) et une deuxième couche de support (602), les première et deuxième couches de support (601, 602) comprenant un plastique renforcé de fibres de verre, GFRP, et
dans lequel l'au moins une couche conductrice (611 ; 612 ; 713) est disposée entre les première et deuxième couches de support (601, 602).

4. Dispositif électronique pliable (100) selon l'une quelconque des revendications 1 à 3, dans lequel l'au moins une couche conductrice (611 ; 612 ; 713) est configurée pour interagir de manière électromagnétique avec un objet externe en comprenant une première couche conductrice (911) comportant un ensemble de premières structures conductrices (1010) s'étendant dans une direction parallèle à un axe de pliage, et une deuxième couche conductrice (912) disposée sous la première couche conductrice (911) et comprenant un ensemble de deuxièmes structures conductrices (1020) s'étendant dans une direction perpendiculaire à l'axe de pliage.

5. Dispositif électronique pliable (100) selon l'une quelconque des revendications 1 à 4, dans lequel l'au moins une couche conductrice (611 ; 612 ; 713) comprend :
une première couche conductrice (611) reliée à une partie conductrice dans le dispositif électronique pliable (100) et servant de masse, et
une deuxième couche conductrice (612) reliée à la première PCB et à la deuxième PCB et servant de ligne de transmission,
dans lequel la plaque de support (430) comporte une pluralité de fentes, la pluralité de fentes étant disposée de manière à chevaucher la structure de charnière, et
dans lequel l'au moins une couche conductrice (611 ; 612 ; 713) comprend un motif conducteur dans la première couche conductrice (611) correspondant à au moins quelques-unes de la pluralité de fentes comprenant une pluralité d'ouvertures.

6. Dispositif électronique pliable (100) selon l'une quelconque des revendications 1 à 5, dans lequel l'au moins une couche conductrice (611 ; 612 ; 713) comprend au moins deux couches conductrices, et
dans lequel la plaque de support (430) comprend une couche non conductrice (621 ; 722) intercalée entre les au moins deux couches conductrices.

7. Dispositif électronique pliable (100) selon la revendication 6, dans lequel la couche non conductrice comprend un matériau identique à celui de la plaque de support (430).

8. Dispositif électronique pliable (100) selon l'une quelconque des revendications 1 à 7, dans lequel la plaque de support (430) comprend un GFRP.

9. Dispositif électronique pliable (100) selon l'une quelconque des revendications 1 à 8, dans lequel l'au moins une couche conductrice (611 ; 612 ; 713) comprend un motif conducteur disposé de manière à chevaucher la structure de charnière,
dans lequel le motif conducteur comprend :
une première ligne conductrice s'étendant entre une pluralité de fentes disposées dans une zone de pliage de la plaque de support, et
une deuxième ligne conductrice espacée de la première ligne conductrice et s'étendant entre la pluralité de fentes, et
dans lequel le motif conducteur est configuré pour transmettre un signal de la première PCB à la deuxième PCB.

10. Dispositif électronique pliable (100) selon l'une quelconque des revendications 1 à 9, dans lequel l'au moins une couche conductrice (611 ; 612 ; 713) comprend une première ligne conductrice et une deuxième ligne conductrice,
dans lequel le motif conducteur s'étend en serpentant entre une pluralité de fentes disposées dans une zone de pliage de la plaque de support et espacées les unes des autres.

11. Dispositif électronique pliable (100) selon l'une quelconque des revendications 1 à 10, dans lequel la plaque de support (430) comprend :
une première couche de support disposée entre une surface de l'au moins une couche conductrice et le panneau d'affichage (401), et
une deuxième couche de support disposée sur une autre surface de l'au moins une couche conductrice (611 ; 612 ; 713).

12. Dispositif électronique pliable (100) selon l'une quelconque des revendications 1 à 11, dans lequel l'au moins une couche conductrice (611 ; 612 ; 713) comprend une première couche conductrice et une deuxième couche conductrice, les première et deuxième couches conductrices étant reliées à la première PCB et à la deuxième PCB, et
dans lequel la première couche conductrice est reliée électriquement à la deuxième couche conductrice par l'intermédiaire d'un via conducteur disposé dans une couche non conductrice située entre la première couche conductrice et la deuxième couche conductrice.

13. Dispositif électronique pliable (100) selon l'une quelconque des revendications 1 à 12, dans lequel la plaque de support (430) est configurée pour réduire la distorsion du signal transmis à travers l'au moins une couche conductrice (611 ; 612 ; 713) en comportant en outre une couche de blindage comprenant du graphite ou des pâtes métalliques sur une surface faisant face à la première PCB et à la deuxième PCB.

14. Dispositif électronique pliable (100) selon l'une quelconque des revendications 1 à 13, comprenant en outre un troisième boîtier couplé de manière rotative au deuxième boîtier (120),
dans lequel l'au moins une couche conductrice (611 ; 612 ; 713) est reliée électriquement à une troisième PCB disposée dans le troisième boîtier.

15. Dispositif électronique pliable (100) selon la revendication 14, dans lequel l'au moins une couche conductrice (611 ; 612 ; 713) comprend :
une première partie conductrice (811) intégrée dans une première partie plane (431) de la plaque de support (430) correspondant à une première partie d'affichage (141) de l'affichage flexible (140) disposé sur le premier boîtier (110),
une deuxième partie conductrice (812) intégrée dans une deuxième partie plane (432) de la plaque de support 430, correspondant à une deuxième partie d'affichage (142) de l'affichage flexible (140) disposé sur le deuxième boîtier (120), et
une troisième partie conductrice (813) disposée dans une troisième partie plane de la plaque de support (430) correspondant à une troisième partie d'affichage flexible (140) disposé sur le troisième boîtier (130), et
dans lequel la plaque de support (430) comprend :
un premier connecteur (511) reliant la première PCB et la première partie conductrice (811),
un deuxième connecteur (512) reliant la deuxième PCB et la deuxième partie conductrice (812), et
un troisième connecteur (513) reliant la troisième PCB et la troisième partie conductrice (813).
